(19) **Europäisches Patentamt**
**European Patent Office**
**Office européen des brevets**

(11) **EP 1 164 694 B1**

(12) **EUROPEAN PATENT SPECIFICATION**

(45) Date of publication and mention
of the grant of the patent:
**14.05.2014 Bulletin 2014/20**

(51) Int Cl.:
*H03F 1/32* (2006.01)      *H03F 1/02* (2006.01)
*H04L 27/34* (2006.01)     *H04L 27/38* (2006.01)
*H03G 7/00* (2006.01)      *H04L 1/20* (2006.01)
*H04L 27/36* (2006.01)

(21) Application number: **01114397.1**

(22) Date of filing: **14.06.2001**

(54) **Microwave amplifier**

Mikrowellenverstärker

Amplificateur hyperfréquence

(84) Designated Contracting States:
**AT BE CH CY DE DK ES FI FR GB GR IE IT LI LU MC NL PT SE TR**

(30) Priority: **16.06.2000 IT MI001360**

(43) Date of publication of application:
**19.12.2001 Bulletin 2001/51**

(73) Proprietor: **Nokia Siemens Networks Italia S.p.A.**
**20060 Cassina de Pecchi (MI) (IT)**

(72) Inventors:
• **Abbiati, Antonio**
**26866 Sant'Angelo Lodigiano (IT)**

• **Buoli, Carlo**
**San Martino Spino,**
**41030 Mirandola (MO) (IT)**
• **Cervi, Luigi Antonio**
**26010 Olmeneta (CR) (IT)**

(74) Representative: **Fischer, Michael et al**
**Nokia Siemens Networks GmbH & Co. KG**
**COO RTP IPR, Patent Administration**
**80240 München (DE)**

(56) References cited:
**EP-A- 0 501 448      EP-A- 0 630 131**
**EP-A1- 0 584 534     EP-A2- 0 451 909**
**US-A- 4 766 395**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Field of the invention

The present invention relates to the sector of amplitude, or amplitude and phase modulated radio signals transmission, and more in particular, to a method and system for microwave transmission and reception of a level wide dynamic signal in the modulation envelope.

### Background art

As it is known, in the sector of the technique specified above, mainly concerning transmission systems in digital radio link, or short distance radio connections made through transceivers installed on trellis, we can notice an increasing request to accommodate an ever-higher quantity of information in the channel band. In fact, communication techniques have been advancing in offering broad band services to the users. This need involves that the radio system designers research an ever-increasing effectiveness in the exploitation of the spectral resource. To this purpose, point-to-point professional communication systems have almost completely abandoned the traditional amplitude modulation AM in analogue technique in favour of an amplitude and phase modulation of the discrete type, known as QAM. Through this type of modulation, the possible values of the component in phase and in quadrature of the modulated carrier intercept a same number of points on a Cartesian plan on which a phasor is shown, representing the modulated carrier. The whole of the points forms a so-called constellation. 256-point QAM constellations are considered common and 512 or 1.024 point constellations are also used. The QAM modulation, operating on discrete values of the base band signal, can conveniently make use of digital algorithms to improve the spectrum effectiveness and render the system more immune to noise and to the different interference causes. To this purpose the original constellations can be transformed according to schemes associating the QAM modulation to particular coding, such as for instance in the TCM technique (Trellis Code Modulation).

The exploitation of increasingly complex constellations involves in reward the necessity to assure a great linearity in the transmission channel; this is absolutely necessary to meet the difficulty in demodulation in presence of a lesser extension of the intervals between the discrimination thresholds of adjacent points. A second need to be faced derives from the fact that as the number of points of the constellation increases also the transmission power increases, that means having to support higher consumption, equipping more expensive supply devices. The increase in transmission power is due to the fact that as the number of points of the constellation increases, also the value of the ratio between the peak power of the modulation envelope, associated to the more distant points from the origin of the constellation, and the average power associated to the all the points of the same also increase. The satisfaction of the requirement concerning linearity cannot leave out of consideration an adequate amplification of the transmitted signal on longer distances, absolutely necessary not to degrade the signal noise ratio at the receiver input. If we do not want over-dimensioning the final amplifier for cost reasons, the additional amplification requires the exploitation of the maximum dynamic of the amplifier device transfer characteristic that, as already known, shows a highly non linear knee area. It is then evident that on the power peaks, the amplifier device could outcome easily stressed in the first non-linearity area.

From the above, it appears a conflict between the need to increase the spectral effectiveness having recourse to complex QAM schemes and the need to reduce the costs and consumption of the transmission equipment. The conflict is caused by the fact that the first need involves high linearities and higher transmission powers, made more necessary by the need of a good quality of the signal, and these requirements are difficult to reach at low cost, through the transmission equipment of the known art.

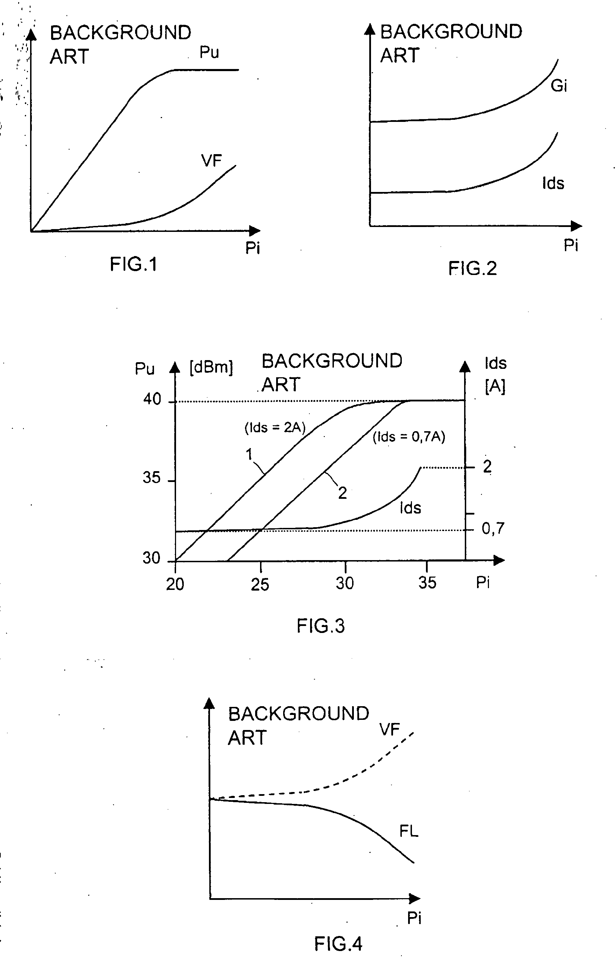

To support what stated on the intrinsic non-linearity of a radiofrequency power amplifier device, typically a FET, **Fig. 1** shows the qualitative trend of the output power Pu and of the phase variation VF according to the power Pi entering said device. The curves of Fig.1 show highly non-linear trends starting from a knee area, matching which the FET generates inter modulation products. In lack of appropriate measures, it would be very difficult for the transmitter to meet the requirements commonly imposed by the masks defining the limits of the channel. More in general, the reduction of the gain at the highest powers of the input signal involves an amplitude distortion of the radiofrequency amplified signal and a phase distortion due to the conversion from amplitude modulation to phase modulation. The first distortion is called AM/AM (AM = Amplitude Modulation), while the second one AM/PM (PM = Phase Modulation), both are functions of the input power and of the device used.

The more traditional measures enabling to expand the dynamic of the linearly amplified signal, are represented by the introduction of convenient pre-distortion linearizers upstream the radiofrequency final power amplifier device. Also in presence of linearizers, and assuming the amplification properly distributed among the different stages of the transmitter, the higher power requested in transmission results even in worsening the performances of other elements involved in the transmission chain, such as for instance the intermediate frequency section and the frequency converter diodes, causing a degradation of the performances of the different devices used and a consequent increase of the total power of noise and of the intersymbol interference ISI (InterSymbol Interference) downstream the transmitter.

The drawbacks highlighted above with particular emphasis for the modulated signals QAM however concern the transmissions of the amplitude modulated signals in general, that is, also those of the traditional AM (Amplitude Modulation) type. However, the QAM modulation has the design advantage of more simplicity in determining the peak factor, intended as the amplitude of the power peak Pp of the modulation envelope compared to the average value Pm of said envelope. In the QAM modulations the peak factor consists of two components: a static component, due to the constellation shape and dimension, and a dynamic one due to the roll-off of the transmission impulse shaper filter. In general, filtering is equally divided between reception and transmission to ease the transmission filter, thus limiting the stresses to the transmitter where the higher signal power flows. In the case of a 128 QAM modulated signal and a 0.5 roll-off of the transmission filter, the total peak factor Pp/Pm is 6.7 dB.

In traditional AM modulations the determination of the Pp/Pm ratio is not so simple since it depends on chance on the type of transmitted signal; however, in some cases extensive studies have been conducted on the signal in base band, from which the extension to the amplitude modulated signal is immediate. These studies led to the determination of peak values in given conditions and with a given reliability. In the case of the voice signal of the telephone type, we can mention for instance paragraphs 2.4 (SIGNAL AND NOISE PARAMETERS) and 3.1 (THE SPEECH SIGNAL) of the volume under the title "TRANSMISSION SYSTEMS FOR COMMUNICATIONS", fifth edition 1982, published by Bell Telephone Laboratories, Inc. In paragraph 2.4 of the book, reference is made to an empirical method for the measurement of the average and peak electric power generated by the voice (or music) signal in use since 1940; the method is called "Volume Unit" (vu). Employing that method it was found that power peaks were approximately 15 dB over the vu measure of the equivalent electric power. Paragraph 3.1 refers also to a more advanced measurement method, called Equivalent Peak Level (EPL) method based on objective measurement criteria of the peak power. In the continuance of the paragraph, it is also said that more recent observations on telephone signals employed the EPL method associated to measurements of the long-term average power of conversations. The results indicated that the distribution of the power peaks in trunk-calls in the United States was characterized by a mean of -11,1 dBm0 and a standard deviation of 4,7 dB. Likewise, the distribution of average powers of the same telephone calls could be characterized by a mean of -25,5 dBm0 and a deviation standard of 5,3 dB. The distribution of EPL measurements and of the average power measurements had a trend approximately Log-normal (which results being Gaussian when the independent variable is expressed in dB). Therefore, the conclusions were in agreement with the measurements of the previous method vu.

The possibility to know in advance the value of the Pp/Pm ratio of the modulation envelope, enables in the transmission systems of the known art to position at best the working point of the final radiofrequency power amplifier device in order to preserve the operation linearity on the signal peaks. The results of the study made on telephone signals is however applicable to the case of transmission of voice signals generated by a single speaker, such as for instance it occurs in the common AM amateur- or circular diffusion transmissions, since in the case of multiplex telephone signals the power transmitted is always the one averaged on the great number of speakers.

In transmission systems based on the amplitude and/or phase modulations, the more known countermeasures taken to increase the linearity of the transmission channel as a whole and reduce noise and intersymbol interference are as follows:

a) The use of an equalizer in reception to perform non-linear filtering operations on the signal received to the purpose of cancelling the intersymbol interference generated by non-linearity present on the channel. The specialized literature offers several examples of equalizers useful to the purpose, of the fixed or adaptive type, the latter dynamically adequate their filtering to the variations in time of the characteristic of the transmission channel.

b) As already said, the insertion of a radiofrequency analogue pre-distorter upstream the FET power microwave amplifier. The pre-distorter expands the level of the amplifier input signal coinciding with the area of the curve knee Pu(Pi) of **Fig.1** and at the same time causes the variation of its phase in a way opposite to the trend of the phase distortion between input and output represented by the curve VF of Fig. 1. The expansion of the dynamic enables to compensate said knee and continue for a given length the linear course of power Pu even in the saturation area, up to reaching the horizontal course of the curve, that can no more be compensated. **Fig. 2** is drawn from the European patent No. 0 451 909 released in the name of the same Applicant; it shows the trends of the power gain Gi and of the polarization current Ids (drain-source) according to the input power Pi of a GaAsFET that can be used as microwave amplifier and at the same time as pre-distortion linearizer of itself, or only as pre-distorter placed upstream another amplifier device whose characteristic Pu(Pi) has to be linearized. The desired result has been obtained sub-polarizing the GaAsFET close to the pinch-off area, as described in claim 1 of the mentioned patent. **Fig. 3** is drawn from the same patent and shows two trends of the output power Pu depending on the input power Pi for two relevant values of the polarization current Ids. In the figure, it can be noticed that matching the lowest correspondence polarization current Ids, corresponding to a value of initial sub-polarization in the area close to the pinch-off, the effects of the gain increase extend the linearity area of the power transfer function close to the knee. **Fig. 4** is drawn from the same mentioned patent and shows the trend of a phase pre-distortion curve FL, specular versus the phase distortion VF curve of Fig.1. The FL curve is generated by a variable phase shifting network, with varicap diodes driven by the drain voltage of the GaAsFET belonging to the pre-distorter.

The countermeasures to guarantee linearity in transmission described below concern more in particular the sole QAM modulations:

c) Pre-distortion of digital data in order to modify the constellation used to pilot the non-linear amplifier, which due to non-linearity tends to return the starting constellation. In practice, a pre-distortion similar to that obtained by an analogue linearizer is performed in digital.

d) Use of rectangular constellations with an odd number of points, since the same have no points on the sharp corners to which a higher power is associated; or in an absolutely equivalent way, use of particular pseudo-circular constellation shapes.

e) Selection of particular symbol sequences showing high peak powers in the filtered digital signal and replacement of the same by other sequences characterized by lower power peaks; transmission of the signal resulting through a channel affected by non linearity; reception of the transmitted signal, interception of the replacing sequences and restoration of the original symbol sequences.

The method mentioned under the previous point e) is described in the European patent application No. 0 584 534 A1 in the name of ALCATEL and seems to represent up to date, the known art more close to the invention that shall be described; an adequate comment is therefore necessary. With reference to Fig. 2 of the ALCATEL document we see a processing block (implemented as a digital encoder) performing the above mentioned replacement of sequences in transmission (and dually in reception) acting as a sequential stage machine; each stage being defined by a corresponding sequence of N outgoing symbols. The above-mentioned processing block includes a mapping block MAP at one input and M+MR outputs, a multiplexer MUX having M+MR inputs and one output, and an element delay of a symbol time T. The MAP block starting from a generic sequence of N symbols at its input, generates M+MR blocks of N bi-dimensional symbols, as are the points in a constellation extended versus the M original points. Each block of symbols is relevant to a "status" of the system representing the best sequence to transmit in presence of a given status. The M+MR outputs of the MAP block are connected to a same number of inputs of the MUX block, whose selection input is connected to the output of the delay element T delaying by a symbol time the block of symbols coming out from the multiplexer MUX. The multiplexer MUX selects among all the symbol blocks at its inputs, the one most appropriate to be transmitted compatibly with the previous status. The criterion according to which the MAP block encodes the M+MR symbol blocks, has been previously determined evaluating the impulse response of the transmission filter (placed downstream) coinciding with the possible symbol blocks of the extended constellation, and assigning a weight W to each block as lower as the power peak of the filtered signal is. Of course, the M+MR sequences having the lighter weight shall be selected.

From what said above it can be understood that this operation mode based on the symbol sequences results rather complex in itself. Moreover, the fact that the original constellation is enriched with additional points, actually makes the method inapplicable in presence of multipoint constellations, contrarily to the assumptions made in the introduction, in which the need to have recourse to multipoint constellations to satisfy the requirements of higher spectral effectiveness in transmission was highlighted.

An additional limitation of the ALCATEL method is that not to find immediate application in the analogue field, since the method originates in a perspective mainly oriented to digital modulations; this leads to applications requiring symbol sequences of the modulated signal and that consider sample sequences of the impulse response of the transmission filter. Consequently, the method application is precluded to those signals subject to amplitude-only analogue modulation, just as the usual AM signals.

**Scope of the invention**

The present invention intends to remedy the drawbacks of the background art due to the fact not to be able to properly conjugate the requirements of a high spectral efficiency, which as it is well known, can be reached employing QAM modulated signals characterized by multipoint constellations, with the reproduction fidelity of the demodulated signals, low power consumption of the transmitter, and lower costs of equipment in general.

Further object of the invention is to extend the advantages that can be obtained for the QAM modulation to signals transmitted in sole amplitude analogue modulation showing a wide level dynamic in the modulation envelope, as for instance the common AM signals generated in amateur- or professional equipment.

**Summary of the invention**

To attain this purpose, scope of the present invention is a radiofrequency transmission and reception method of amplitude, or amplitude and phase modulated signals, having a wide level dynamic in the modulation envelope, as described in claim 1.

Further object of the invention is a transmission and reception system applying the method of claim 1, as described in a relevant appended claim.

An additional object of the invention is a first embodiment employing a negative feedback network capable of acting on the device that increases the gain placed in the receiver, to the precise purpose of varying the expansion quantity of the level dynamic to introduce in reception, to compensate the amount of compression of the level dynamic introduced in transmission, as described in a relevant appended claim.

The input variable of the feedback network according to the first embodiment of the invention is any quality parameter of the demodulated signal suitable to the purpose. In the case of modulated signals QAM, a possible parameter is represented by the frequency of FEC (Forward Error Correction) impulses. On the contrary, in the case of modulated AM signals, the ratio between the peak value and average value can be measured within a given pre-determined time slot and then compare the measured value with the value of said ratio obtained through statistical evaluations relevant to the type of transmitted signal, the difference forming a quality parameter as mentioned above for the expansion control.

Further object of the invention is a second embodiment valid for the sole QAM signals, in which the compression and the relevant expansion are digitally made in modulation/demodulation phase directly acting on the components in phase and in quadrature that shall form the modulated /demodulated signal.

The idea laying at the basis of the invention can appear curious at a first analysis, because the compression of the signal dynamic entering the transmitter is an operation that, considered in itself, can but worsen the quality of the transmitted signal; of course the extent of distortion introduced shall be such that the observance of the masks specified for the transmission signal is however guaranteed. Dually in reception, the expansion of the dynamic of the signal at the demodulator input is an operation that, considered in itself, can but worsen the demodulated signal. However, the combination of the two operations does not give back the starting condition, but considerably increases the fidelity of the demodulated signal, contrarily to what could appear logic at first. Seemingly, there is a synergy capable of bettering the global operation of the system. The novel conception, explained in the appended claims cannot of course be changed by the analogue pre-distorters, which perform a level expansion operation on the signal to transmit which is conceptually the contrary of the compression made according to the invention. Not even the background art mentioned as more pertinent, that is the ALCATEL document, evidently suggests the idea implemented by the present invention to solve the common technical problem, consisting in obtaining a good fidelity of the QAM demodulated signal, notwithstanding the presence of devices potentially able to introduce AM/AM and AM/PM distortions on the channel. The method solving the above mentioned technical problem, for what already said concerning the ALCATEL method, foresees the use of an essentially digital technique based on a sequential-stage machine, partially or totally realisable in a combinatory way, capable of processing a sequence of N input symbols to generate a sequence of outgoing N symbols more suitable to be transmitted in presence of an assigned transmission filter. Dual means are envisaged in reception.

The approach adopted by the present invention to solve the technical problem highlighted is on the contrary essentially "uanalogue", even if the second embodiment of the invention valid for QAM modulations foresees the use of digital means, however applying the same essentially analogue approach. In fact, as it results from the claims, the idea followed up by the invention is to compress/expand the sole amplitude of the modulated signal, without altering its phase, employing to this purpose amplification having variable gain whose trend matches that of the amplification gain of differently polarized operative devices. Considered in isolation this last feature is well known in the art see for example US 4766395 published on 23 August 1988, relevant to vary the conductance of a FET to conform to a predetermined function of a control signal applied to the gate of the FET, but it is never used before for linearizing a transmitter and a receiver in tandem. This means that compression/expansion operations originate just as operations of essentially analogue nature, that is, inevitably tied to amplification. The knowledge of the peak factor of the modulated signal enables to foresee the amount of amplitude compression/expansion to introduce to neutralize the relevant effects, and therefore go back to the shape of the most suitable curve.

In the QAM case of the second embodiment the compression/expansion function assumes a discrete number of values coinciding with new symbols of a distorted constellation versus the original one due to deformations introduced by the above mentioned function. The in-phase and in-quadrature components of the modulation vector in the points of the distorted constellation are calculated as before made, that is assuming a compression/expansion function able to neutralize the effects of a known peak factor, and employing this function to tabulate the component values. The mathematical expression of the above mentioned function can be obtained, for instance, combining the known mathematical functions, or from the interpolation between pre-determined points of a curve purposely marked, or applying known mathematical methods useful to this purpose. This procedure is definitely different from that of the ALCATEL method, here there is no sign of generation of symbol sequences and of the selection of one of them to be preferred on the basis of a weight that considers the power peak of the impulse response of the transmission filter. The "analogue" approach to the solution of the technical problem procures that all the causes contributing to the power peak are accumulated in a peak factor, calculated or estimated, afterwards the restriction to keep the phase of the modulation vector unchanged in the following processing, involves the fact to act only on the vector amplitude and therefore of its in-phase and in-quadrature components. At this point, the approache already discussed for the more general "analogue" embodiment of the invention can be easily transferred to the digital embodiment, that is the amplitude compression function of the modulated signal, made appropriately discrete. Dual reasonings apply to the expansion function.

**Advantages of the invention**

The present invention has such a generality to enable its use in presence of common AM modulations or in presence of QAM modulations. It confers the capacity to best employ the radio resource to a transmission and reception system employing the same, even when a wide level dynamic in the modulation envelope characterizes the modulated signals. The difficulties of the known art deriving from the consideration to be given to sequences of QAM symbols and sequences of samples of the impulse response of the transmission filter are completely avoided.

The amplitude compression/expansion law of a signal defined as above leads to consider the trend of a variable amplification gain whose is similar to the gain trend of common amplification electronic devices (such as for instance GaAsFET for signals at microwaves), which do not result in general easy to find and at low costs. Using these devices, as it is well known, the negative slope of the gain curve is caused by saturation phenomena. The opposite trend, that is that of a gain curve having positive slope starting from a given point on, is similar to the gain trend of the polarized GaAsFET close to the pinch-off described in the above mentioned European patent of the same Applicant. The use of compression/expansion means consisting of amplification electronic devices differently polarized enables the application of the invention in transmission and reception equipment for modulated signals AM or QAM, without distinction. The amplification electronic devices employed as compression/ expansion means, though designed to work at microwaves, are conveniently used at intermediate frequency where they show negligible parasite reactance and therefore do not introduce variations in the phase. The compression of the IF signal relaxes the operation of the radiofrequency power amplifier, which therefore does not introduce any phase distortion or introduces it in a negligible quantity. All the remaining devices downstream the compression device can operate in more eased and linear conditions, consequently the system as a whole results more resistant also concerning the variations of the main operation parameters with temperature, environmental conditions, and ageing.

The amplitude compression/expansion law that can be obtained employing the above mentioned analogue means is in general sufficient to reach the targets of the invention. In this case the persistence in following up the trend of an ideal curve expressed in a strictly mathematical way is decidedly uncalled for. This type of accuracy seems difficult to reach in analogue environment; however, it is always possible to select the amplification devices and design the relevant polarization circuits in order to better approximate the desired curve.

On the contrary, whenever, exceptionally, the shape of the curve to synthesise would significantly deviate from the one that can be obtained in an analogue way, recourse could be made to the second embodiment of the invention valid for QAM signals only, which does not require the above-mentioned compression and expansion electronic devices. In this case the compression/expansion of the QAM signal is digitally made in base band (or at the digital intermediate frequency) modifying as desired the in phase I and in quadrature Q components of the original QAM symbols.

Irrespective of the different analogue or digital typology of the compression/ expansion means of the amplitude dynamic actually used, these means can be used alone or in addition to the common linearization means of the channel. In both the cases the system can reach a fidelity attested by extremely low BER values, that enable the adoption of QAM modulations having constellations with the highest number of points (up to 1.024), reaching a higher spectral efficiency without having to over-dimension the transmitter to cope with the topmost power peaks.

**Description of figures**

The present invention together with further objects and advantages thereof may be understood with reference to the following detailed description taken in conjunction with the accompanying drawings, in which:

- **Fig. 1** shows the characteristic transfer functions of a device at the solid state (GaAsFET) used as microwave amplifier;
- **Figures 2, 3 and 4** shows the curves representing the operating rates of a pre-distorter according to the background art, that can be used as linearizer;
- **Fig. 5** shows a transmission and reception system according to the background art employing amplitude modulated signals of the AM or QAM type;
- **Fig. 6** shows a transmission and reception system according to the background art employing modulated QAM signals and a linearized transmitter TRXL;
- **Fig. 7** shows a transmission and reception system according to the present invention for the more general application;
- **Figures 8** and **9** show the diagrams representing the operation of COMPRES and EXPAND blocks of Fig. 7;
- in **Fig. 10** shows a dynamic compressor/expander circuit employed in COMPRES/EXPAND blocks of Fig. 7 of the system according to the invention;

- **Fig. 11** shows a control circuit employed in the AM/AM-CONTR block of Fig. 7 of the system according to the invention;
- **Fig. 12** shows a flow chart representing the operation of the AM/AM-CONTR block of Fig. 11 ;
- **Fig. 13** shows the transmission sub-system of the transmission and reception system according to the present invention, in a particular application case;
- **Fig. 14** shows the embodiment of the transmission and reception system according to the present invention;
- **Fig. 15** shows two points of a constellation involved in the application of embodiment of Fig. 14;
- **Fig. 16** shows two superimposed frequency spectrums that can be evaluated at the output of blocks QAM-MOD (curve a) and TRXL (curve b) respectively of Fig. 6 in presence of a 128 QAM modulation;
- **Fig. 17** shows two superimposed frequency spectrums that can be evaluated at the output of the MOD block (curve a) and COMPRES (curve b) of Fig. 7 or 13 in presence of a 128 QAM modulation;
- **Fig. 18** shows a mask limiting the allowed spectral density for a channel at the edge of the 6L band; and
- **Fig. 19** shows a mask limiting the allowed spectral density for a channel not at the edge of the 6L band.

## Detailed description of a preferred embodiment of the invention

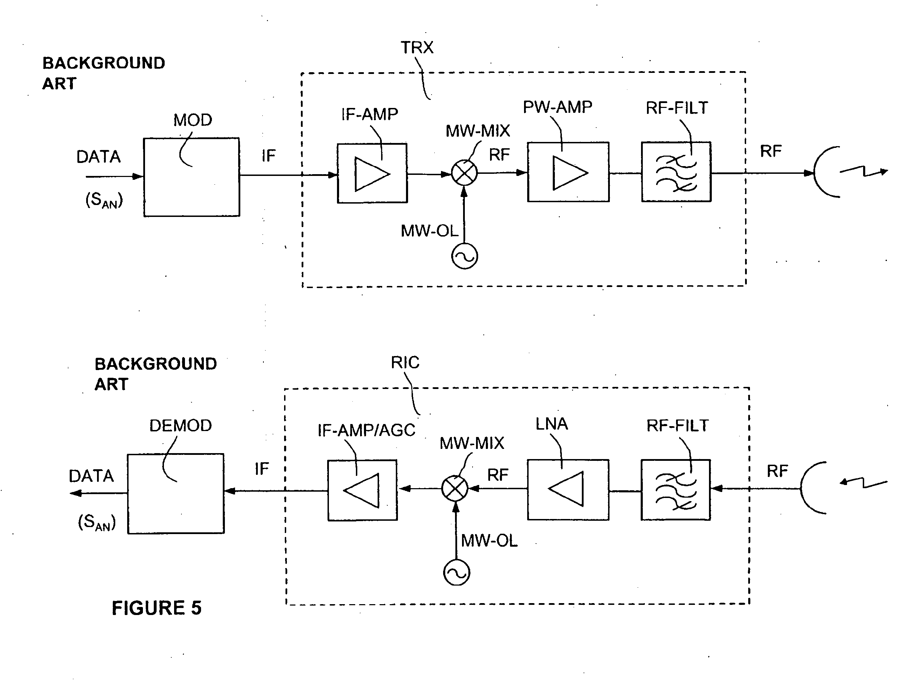

With reference to the upper part of **Fig. 5** it can be noticed a modulator block MOD placed upstream a transmitter TRX. The modulator block schematises either a QAM modulator, in this case it receives at digital data DATI input, or a common amplitude modulator AM receiving at input an analogue signal $S_{AN}$. In both the cases, an analogue signal modulated at intermediate frequency IF comes out from the MOD block, which reaches the input of the TRX block. This last block schematises a conventional transmitter including in turn: an amplifier IF-AMP of the intermediate frequency signal IF, an oscillator MW-OL generating a microwave signal, a mixer MW-MIX receiving at its inputs the intermediate frequency IF and local oscillator MW-OL insignals and converters into microwaves the IF signal obtaining an RF signal, a power amplifier PW-AMP of the RF signal, and an image rejection radiofrequency filter RF-FILT connected to a transmitting antenna.

With reference to the lower part of **Fig. 5** a receiver block RIC can be noticed placed upstream a demodulator block DEMOD. The RIC block schematises a receiver of the conventional type including in turn: a radiofrequency input filter RF-FILT connected to an antenna receiving the RF signal, a low noise linear amplifier LNA placed downstream the RF-FILT filter, an oscillator generating a signal of microwave local oscillator MW-OL, a mixer MW-MIX receiving the reception insignal RF previously low noise filtered and amplified at a first input, and a microwave local oscillator signal MW-OL at a second input and converts the RF signal to intermediate frequency obtaining an IF signal, an amplifier IF-AMP/AGC of the IF signal including the gain automatic control. The demodulator DEMOD receives the analogue IF signal and obtains the demodulated signal in base band that can consist of digital data DATI, in the case of QAM modulated RF signal, or of an analogue signal $S_{AN}$ in the case of AM modulated RF signal.

The transmission system of the known art that can be viewed in Fig.5 does not seem to be able to excellently process the signals having wide dynamic in the ratio between peak power and average power, since no particular measure is envisaged to compensate, or eliminate, the effects of the gain non linearity of the power amplifier PW-AMP.

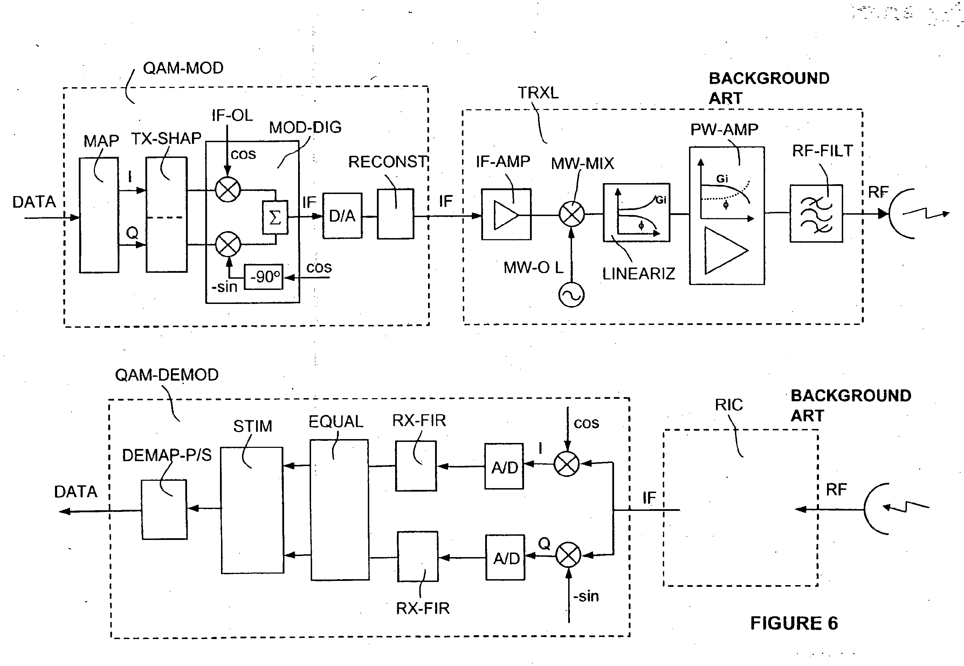

A step forward in this direction is made in the transmission system of the known art visible in **Fig. 6**, referred but not limited, to the sole case of QAM modulations. The upper part of the figure concerns a QAM modulator, denoted QAM-MOD, connected upstream with a linearized transmitter TRXL. On the contrary, the lower part of the figure is referred to the combined receiver RIC, identical to the one shown in Fig. 5, placed upstream a demodulator QAM, indicated with QAM-DEMOD. The QAM-MOD modulator in the particular implementation shown in the figure includes in cascade the following blocks: a mapping block MAP, a transmission impulse shaper filter TX-SHAP, a digital modulator MOD-DIG, a digital to analogue converter D/A, and a reconstruction filter RICOST. In the operation, the mapping block MAP receives a bit string of the DATI signal and transforms it into two sets of symbols orthogonal between them forming a same number of amplitude samples of relevant signals modulating the component in phase I and in quadrature Q of an intermediate frequency digital carrier IF-OL. The mapping operation is generally combined to a channel coding making the system more stout and solving the phase ambiguities in reception. The TX-SHAP filter limits the band of impulsive components I/Q, having symbol frequency, in such a way to avoid the introduction of intersymbol interference. The MOD-DIG block receives a sinusoidal digital signal at intermediate frequency IF-OL, subdivides said signal into two parts and appropriately phase shifts one of them to obtain a sinusoid in quadrature - $\sin(\omega T)$ versus the sinusoid in phase $\cos(\omega T)$, afterwards it multiplies the symbols of I/Q components by $\cos(\omega T)$, $-\sin(\omega T)$, respectively and sends the products to a digital adder $\Sigma$ that sums up the digital signals so amplitude modulated, obtaining the intermediate frequency signal IF, QAM modulated. Said signal is converted to analogue and filtered by the reconstruction filter RICOST before being sent to the input of the TRXL transmitter described later on.

The QAM-DEMOD demodulator in the particular implementation shown in the figure receives the analogue intermediate frequency signal IF outgoing the receiver RIC, subdivides it into two identical signals and multiplies them by the sinusoidal signals $\cos(\omega T)$, $-\sin(\omega T)$, respectively obtained from the reciprocal phase shifting by a common signal of local oscillator at intermediate frequency (not shown in the figure), obtaining an in-phase component I and an in-quadrature component Q of the QAM modulated IF signal, in base band in analogue form. The two I/Q components are converted to digital, filtered by relevant reception digital filters RX-FIR and sent to an equalizer EQUAL that collaborates with filters RX-FIR, possibly coinciding with the latter, to estimate the global impulse response of the channel in order to remove the intersymbol interference. The filtered and equalized I/Q components are sent to a decider block that can conveniently consist of a Viterbi estimator, for the maximum likelihood estimate of the two sequences of symbols of the transmitted signal. The decided sequences are sent to a demapping block DEMAP-P/S, that obtains the starting bit string forming the signal DATI.

The linearized transmitter TRXL differs from the transmitter TRX of Fig. 5 due to the fact that it includes an analogue pre-distorter block LINEARIZ between the output of the mixer MW-MIX and the input of the final power microwave amplifier PW-AMP. The LINEARIX block can be any pre-distorter of the known type capable of compensating the AM/AM and AM/PM distortion introduced by the device used to realize the PW-AMP block. As already said, since the Applicant had patented a linearizer device capable of absolving the two functions of the LINEARIZ and PW-AMP blocks with a single GaAsFET and a varicap diode negative network, it is convenient to employ said invention in the linearized transmitter TRXL. For representation simplicity, a diagram of the trend of gain Gi and of phase $\phi$ that can be evaluated at the output of the amplifier device are shown inside the PW-AMP block, in which non linearities are evident, while a diagram of the gain Gi and of phase $\phi$ that can be evaluated at the output of the pre-distorter device, from which the tentative extent of compensation is shown in the LINEARIZ block. The diagrams inside the PW-AMP and LINEARIZ blocks can be conveniently referred to the centre-band frequency of the radiofrequency signal RF.

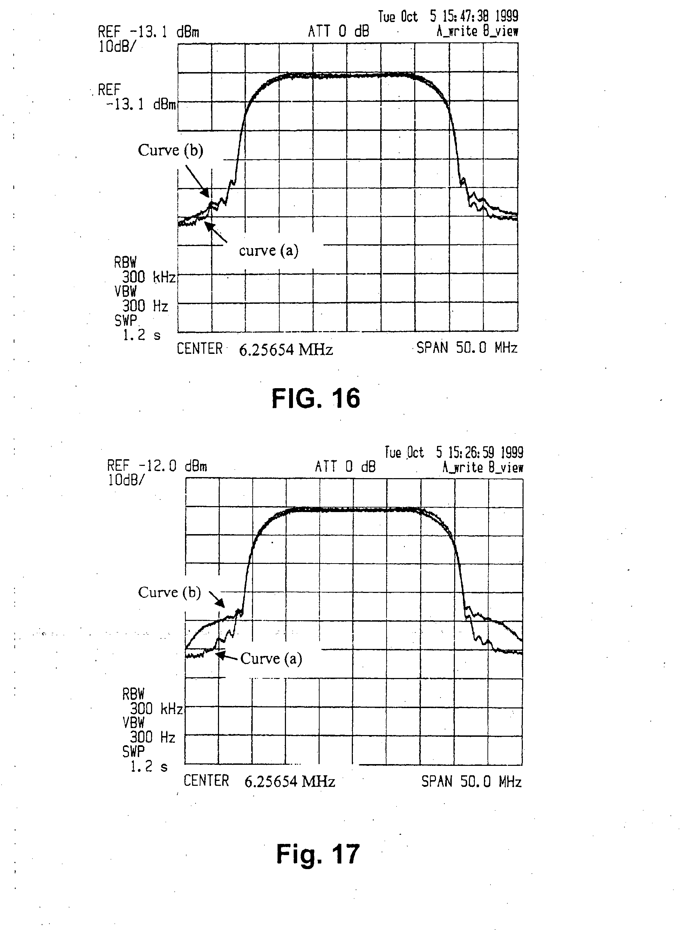

Compared to the non-linearized transmitter TRX of Fig. 5, the linearized transmitter TRXL reaches a higher fidelity in the transmitted signal. The fidelity degree reached can be immediately noticed in **Fig. 16** from the superimposition of the two frequency spectrums evaluated at the output of the QAM-MOD block (curve a) and TRXL (curve b) in presence of a 128 QAM modulation. The BER measured at the output of the demodulator QAM-DEMOD has $10^{-11}$ value that, notwithstanding the low distortion of the transmitter, does not still result completely satisfactory in the case under examination.

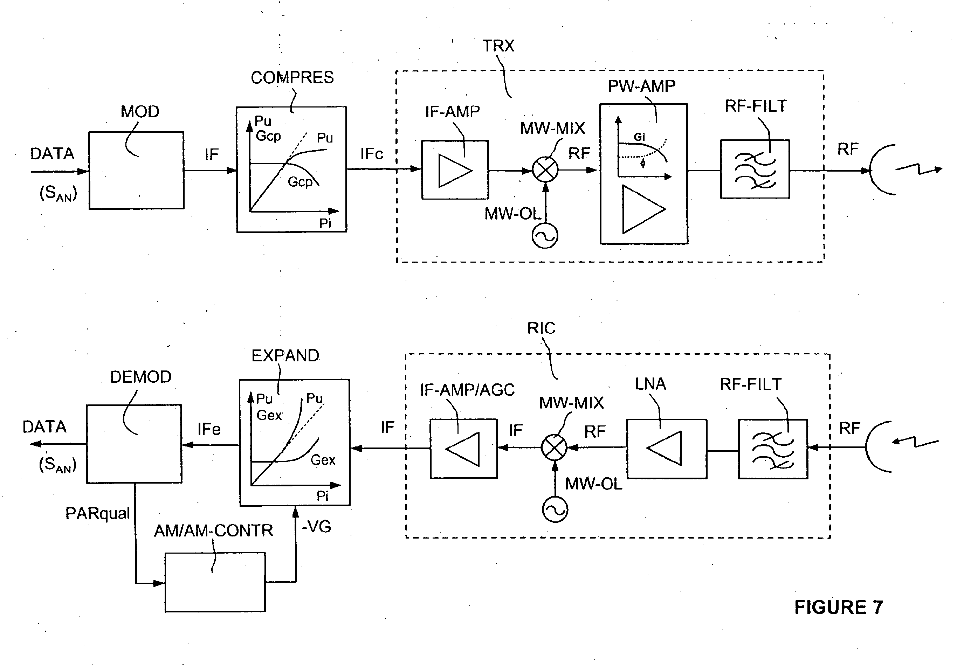

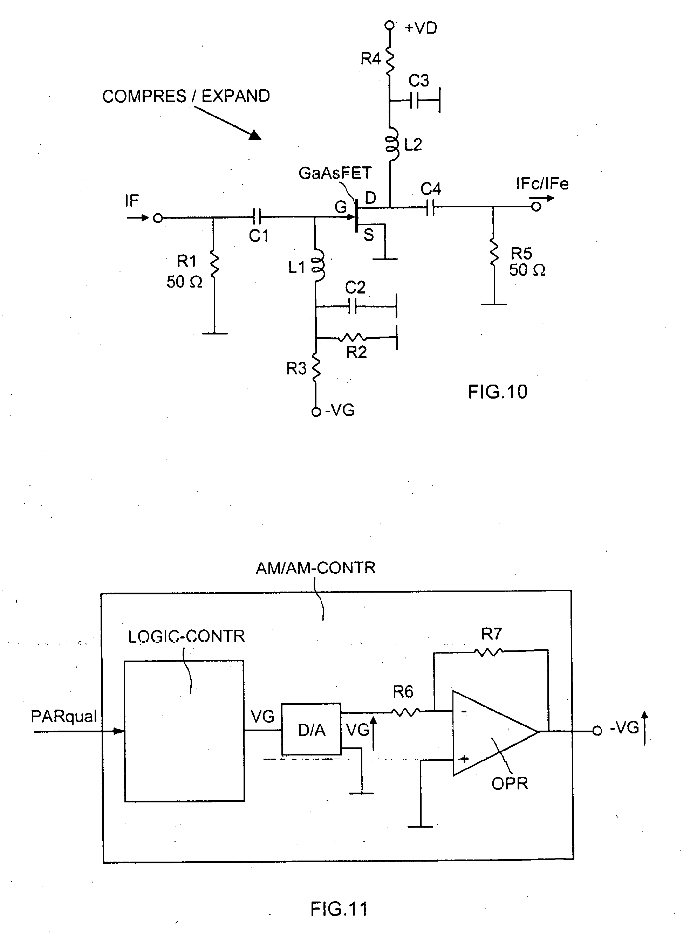

**Fig. 7** shows the transmission and reception system of the present invention, in the more general of application consisting in the association to the transmission and reception system represented in Fig. 5. The system of Fig. 7 differs from the system of Fig. 5 due to the fact that a COMPRES block is inserted between the output of the modulator MOD and the input of transmitter TRX and an EXPAND block is inserted between the output of the receiver RIC and the input of demodulator DEMOD; a feedback block AM/AM-CONTR is also connected between the demodulator DEMOD and the EXPAND block. For representation simplicity, a diagram of the gain Gi(Pi) and phase $\phi$(Pi) trend that can be evaluated at the output of the amplifier device, in which non-linearities are evident is shown inside the PW-AMP block. The circuit description of COMPRES and EXPAND blocks is made with reference to the common Fig. 10. The characteristics of operation of these blocks are however conveniently anticipated showing within the COMPRES block the diagrams of trends Pu(Pi) and Gcp(Pi) according to the input power Pi, indicating the output power Pu and the gain Gcp respectively, and show the diagrams of Pu(Pi) and Gex(Pi) dual trends within the EXPAND block. These trends can be conveniently referred to the centre-band frequency of the IF signal to compress/expand. The phase trends are not shown because the devices employed in the implementation of COMPRES and EXPAND blocks do not introduce phase distortions. The trends visible in the COMPRES block clearly show that due to the variable gain Gcp the peaks of the incoming signal IF are less amplified versus the lower levels of the signal. The compression maximum degree of the dynamic has a value such to never cause a cutting of the incoming signal IF peaks, otherwise the information contained in the incoming signal IF would be unrecoverable by the EXPAND block which acts on the compressed signal obtained from IFc. On the operation side, it is convenient to regulate the maximum compression degree in direct relation with the Pp/Pm ratio between peak value and average value of the modulation envelope.

The EXPAND block shows a variable trend gain Gex opposite to gain Gcp of the COMPRES block, thus eliminating the distortion introduced on the peaks of the incoming IF signal due to the compression made in the transmission phase, in the outgoing signal IFe

The compression/expansion law of the levels of the modulated signal IF performed by COMPRES and EXPAND blocks is freed from possible distortions introduced by the power amplifier PW-AMP; the application of the invention attempts, in fact, to prevent said distortions. However, in accomplishing its task the COMPRES block compresses the level following a law that determines a trend of the Gcp gain similar to the trend of the Gi gain determined by the PW-AMP block, while the EXPAND block generates an opposite trend. This behaviour can be explained by the fact that the particular realization of COMPRES and EXPAND blocks makes use of a FET: in the first case compressing the amplitude dynamic in the knee area of the transfer characteristic Pu(Pi), while in the second case expanding the above mentioned dynamic being polarized close to the pinch-off, as described in the mentioned patented pre-distorter.

The behaviour similarity would not represent a restraint of the invention, which can render its advantages also in presence of a compression law of the amplitude dynamic of the modulated signal IF differing from that characterizing the PW-AMP block, provided that the expansion law has always opposite trend. This statement must be considered keeping in mind the objects of the invention and the technical problem it intends to solve; requirements these that actually limit the possibilities in the choice of the compression curve to curves very similar to those actually described. The applications of the invention in QAM environment are rightly considered the more interesting ones, therefore the considerations on the best shape of the compression curve shall keep into account the representation of the modulation vector through a constellation and of the dynamic behaviour of the same. The compression of the amplitude dynamic made by the COMPRES block (Fig. 7) placed downstream the modulator cannot prevent the vector representing the modulated signal to stray the limits of the original constellation due to the dynamic behaviour. However, the two identical sections of the transmission digital filter TX-SHAP (Fig. 6) placed upstream the modulator MOD-DIG limit overelongations of the modulation vector. In this case it is possible to base with a good approximation on the sole constellation shape the heuristic reasoning for the research of the best trend of the compression curve. In this position it appears natural to expect from a compression curve that it leave the position of the constellation points sufficiently distant from sharp corners unchanged, not to uselessly distort the signal. This means that, if we want to characterize the compression function through the amplification gain function, then for a considerable initial length of the gain function the trend must be kept tendentially constant, that is, no amplitude compression shall be present otherwise it shall be negligible. On the contrary, when the modulation vector tends to go close to the sharp corners a prevention action is necessary, as strong as lower is the distance from sharp corners, which translates into a compression of the vector module; in this case the gain function must show a negative slope. The slope can be constant or have a given variability depending on how quickly one wants to compress the amplitude dynamic. Dually in reception, the expansion curve of the amplitude dynamic made by the concerned device shall show in its variable part a trend opposite to that of the compression curve. Characterizing the expansion function through the amplification gain function, then the gain trend must show an initial length potentially constant that continues with positive slope. The initial length of the gain function starts from the same point in both the gain functions, both in the compression case and in the expansion of the amplitude dynamic.

The implementation of a dynamic compressor/expander through a FET seemed the more immediate and convenient, however a more accurate research could highlight other devices suitable to the purpose. To description purposes, the serviceability of a compressor/expander of the amplitude dynamic, as it results up to now from the example supplied, consists in amplifying the modulated signal IF with a variable gain whose trend resembles that of the amplification gain of the common amplification electronic devices due to their intrinsic nature and to the particular polarization network employed.

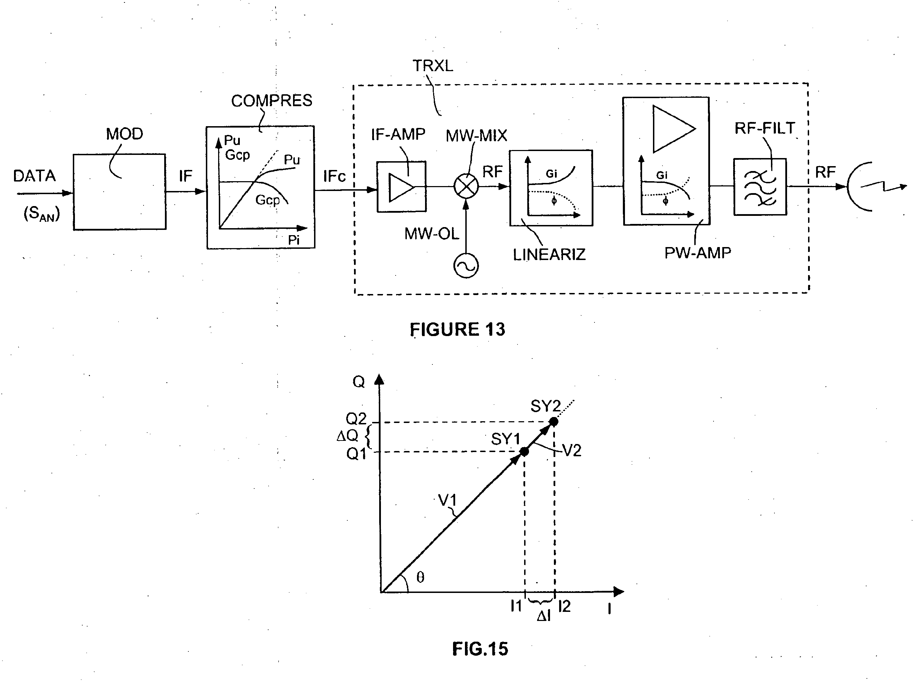

With the aid of **Fig. 15** it is possible to offer, for the QAM modulation only, a given distinctness to the operation of COMPRES and EXPAND blocks. Starting from the COMPRES block, the position of a QAM symbol placed in a corner of the original constellation reached by a vector V2 indicating the modulated signal IF, is denoted SY2. The vector V2 in SY2 is characterized by its module and by a phase θ. Due to compression, the constellation is transformed into a distorted constellation because of the variation in the reciprocal distance between distal points. The new position of the symbol SY2 due to compression is denoted SY1. As it can be noticed, the vector V2 is transformed into a shorter vector V1 but having the same phase θ. Between the I and Q components of vectors V2 and V1 the following relation applies:

$$\frac{Q}{I} = \frac{\Delta Q}{\Delta I} = \tan\theta \qquad\qquad (1)$$

Concerning the EXPAND block, the dynamic expansion brings the vector V1 from point SY1 to point SY2 and the reciprocal relation applies.

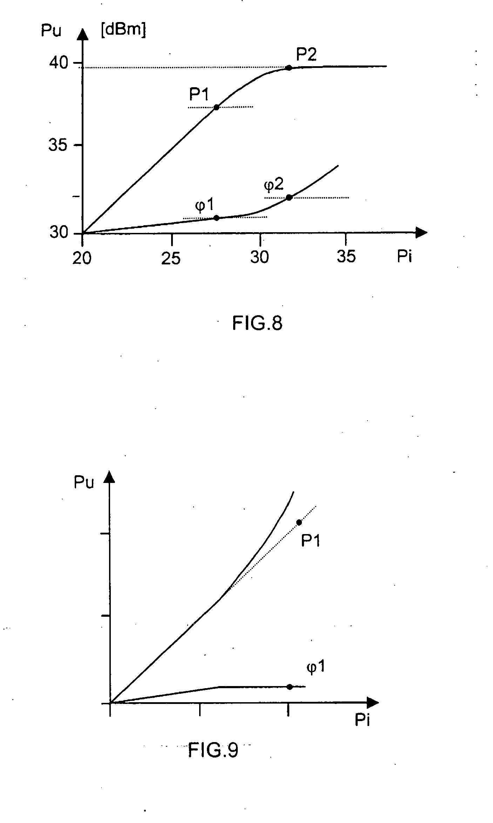

It is worth now to consider the effect of the introduction of the COMPRES block in the operation of the PW-AMP amplifier. **Fig. 8**, equivalent to Fig. 1, helps to this purpose. This figure shows the trend of the outgoing power Pu and of phase φ of the RF signal at the output of the PW-AMP block as the input power Pi varies. Assuming at first that the COMPRES block is lacking, during the peaks of the IF signal the radiofrequency amplified signal RF would reach with good probability a level and a phase indicated by points P2 and φ2, clearly distorting. In presence of the COMPRES block, on the contrary, during the peaks of the IF signal, the amplified signal RF would reach the level indicated by point P1 placed at the border of the linear area of the amplifier device, that in this way operates in an easier manner. Also the phase distortion would be automatically reduced by the level compression, not exceeding the φ1 < φ2 value. The signal in point P1, though being in the linearity area of the PW-AMP amplifier is nevertheless distorted due to the previous compression, but in a controlled and reversible manner.

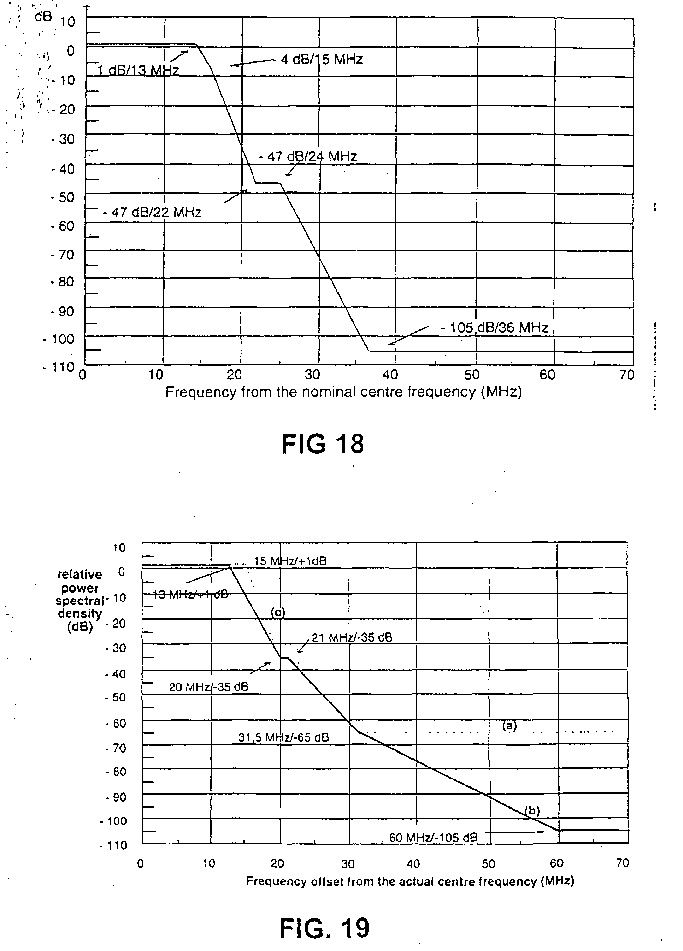

**Fig. 17** shows the extent of the distortion introduced by the COMPRES block on the IF signal in presence of a 128 QAM modulation. The curve (a) in figure indicates the frequency spectrum of the IF signal outgoing the modulator MOD, while the curve (b) indicates the frequency spectrum of the IF signal outgoing the COMPRES block. The curve (b) trend perceptibly deviates from the curve (a) trend highlighting the presence of intermodulation products. Assuming that the devices placed downstream the COMPRES block do not introduce additional distortion, it is fundamental that the spectrum indicated by curve (b) complies with the ETSI masks of **Figures 18 and 19** specified for the transmission signal. The more stringent mask is that of **Fig. 18** relevant to a channel placed at the edge of band 6L, the latter included between 5,9 and 6,4 GHz. From the ideal superimposition of the mask of Fig. 18 to the spectrums of Fig. 17 we notice that the curve (b) matches the mask; therefore it is possible to transmit the frequency spectrum indicated by this curve including the distortion highlighted in the lateral parts of the same.

**Fig. 9** again shows the trend Pu(Pi) visible in the EXPAND block of Fig. 7 and the phase trend of the IF signal. In the figure it can be distinguished that the level expansion reinstates the IF signal outgoing from EXPAND block to a linear trend, while the incoming signal IF resulted distorted by the same extent that afflicted the RF signal matching point P1 of Fig. 8. The two COMPRES and EXPAND blocks act only on the amplitude of the modulated signal, leaving the phase unchanged. Thanks to compression, the amplified power PW-AMP can operate with higher linearity and therefore less distort also the phase, just as shown by the trend of curve $\varphi1$ of Fig. 9.

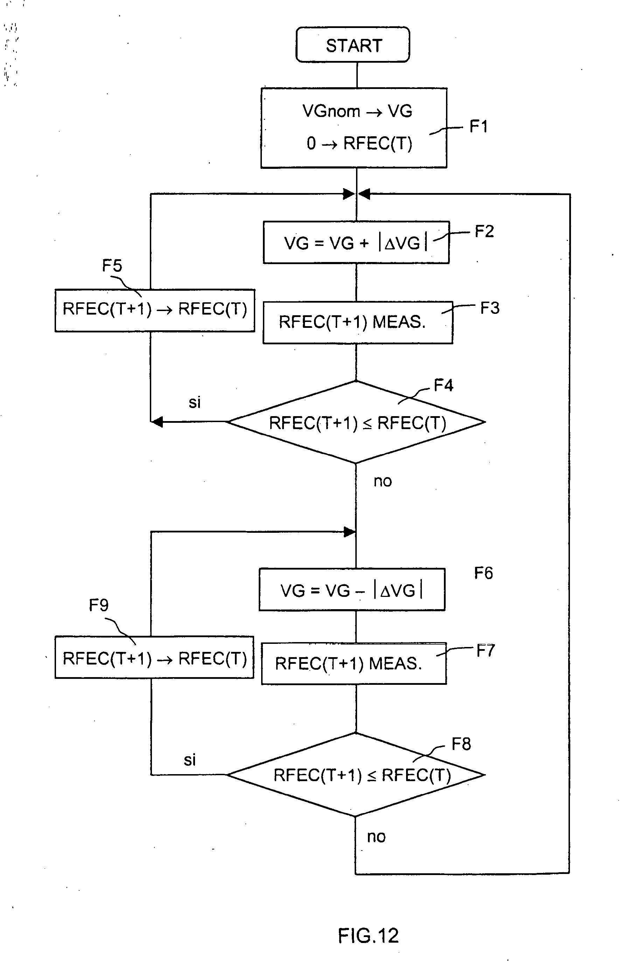

The expansion can be optimized in order to minimize the BER at the output of demodulator DEMOD of Fig. 7. To this purpose provides the AM/AM-CONTR block that receives a quality parameter PARqual of the demodulated signal from the DEMOD demodulator, and on the basis of this parameter processes a $\Delta$VG variation of the voltage controlling a level expansion device included in the EXPAND block. Figures 11 and 12 will show in detail the composition and operation of the AM/AM-CONTR block.

The advantages of the transmission and reception system described with reference to Fig. 7 (followed by the description of subsequent figures 10, 11 and 12) have already been highlighted in the foreword, however, a direct comparison between the performances in terms of BER of the system of the known art of Fig. 6 and the performances of the transmission and reception system of Fig. 7 according to the present invention (in the cases of QAM modulations), enables to appreciate the goodness of the same. As already said, the spectrums of Fig. 16 relevant to the system of Fig. 6 enabled a $10^{-11}$ BER at the output of the demodulator DEMOD in presence of 128 QAM modulation. In comparison, the spectrums of Fig. 17 relevant to the system of Fig. 7 in presence of the same modulation, though that same are less superimposable, they enable to reach a $10^{-14}$ BER at the output of the demodulator DEMOD. This means that the spectrum of the IF signal at the output of the EXPAND block of Fig. 7 has trend perfectly superimposable to that of curve (a) of Fig. 17. So low BER values are adequate to the use of QAM modulations having a high number of points, for instance 1024.

The same performances of the system of Fig. 7 can be obtained in a transmission and reception system, also according to the present invention, employing the transmission sub-system of **Fig. 13**. The latter differs from the corresponding sub-system of Fig. 7 due only to the fact to employ a linearized transmitter TRXL identical to that of Fig. 6, instead of the non-linearized transmitter TRX. The advantage of such a solution is to be able to increase the amplification of the compressed IFc signal without introducing in the RF signal the distortions otherwise generated by the amplification device inside the PW-AMP block in lack of the LINEARIX block.

The COMPRES block of Figures 7 and 13 and the EXPAND block of Fig. 7 can be realized employing circuits or devices not suitable to the purpose. In the specific case it is useful in both the cases to have recourse to a same circuit diagram shown in **Fig. 10**, corresponding to the one described in the sub-polarized FET patent released to the Applicant and previously mentioned.

With reference to **Fig. 10** a transistor of the GaAsFET type can be noticed (supposed to be an n-channel JFET, but not limited to the same) having the gate terminal G connected to an input port of the intermediate frequency signal IF through a by-pass capacitor C1. A 50 $\Omega$ resistance R1 is placed between the end of the capacitor connected to the above-mentioned port and to ground. The gate terminal is also connected to an end of an inductor L1 whose other end is connected to a capacitor C2, to a resistance R2 and to a resistance R3. The capacitor C2 and the resistance R2 have the other end connected to the ground, while resistance R3 has the other end connected to a point reached by a polarization voltage -VG of the gate electrode G. The source terminal of the GaAsFET is directly connected to the ground. The drain terminal D of the GaAsFET is connected to a point reached by a relevant polarization voltage +VD, through the series of a resistor R4 and an inductor L2. The same drain terminal D is connected through a by-pass capacitor C4 to an output port of signals IFc, in the case of GaAsFET utilization as compressor, or IFe in the case of utilization as expander, respectively. A 50 $\Omega$ resistance R5 is placed between the end of the capacitor connected to the said port and to the ground. The elements L1, C2 and L2, C3 are low pass sections blocking the passage of the intermediate frequency signal IF towards the sources of the polarization voltage, of gate and drain, respectively. The resistances from 50 $\Omega$ R1 to R5 adapt the impedance at input and output terminals of the circuit of Fig. 10. R2 and R3 resistances polarize the gate of the GaAsFET; in particular R2 protects the gate not leaving it "suspended". The resistance R4 polarizes the GaAsFET drain.

In the operation of circuit of **Fig. 10** as level compressor, the voltage -VG is set in order to properly position the operating point in the linear area of the transfer characteristic Pu(Pi), where the gain is constant. The measure to obtain compression is to locate the operating point close to the curve knee Pu(Pi) visible inside the COMPRES block, in order that the outgoing signal IFc runs a good length of the knee on the peaks of the IF input signal, without reaching the constant trend area beyond the knee.

In the operation of the circuit of Fig. 10 as level expander, the voltage -VG is set in order to arrange the working point almost close to the pinch-off. In this case the operation non-linearity of the GaAsFET distorts the incoming signal generating a continuous component determining a voltage at the ends of the capacitor C2, different from the polarization voltage -VG due to the resistive divider R3 with R2. Therefore, a self-polarization effect occurs, which as the level of the IF input signal increases, allows the pinch-off voltage to assume values decreasingly negative, enabling a larger current flow in the channel. The effect described, translates into a gain increase (intended as transconductance), and consequently in an increase of the level of the outgoing signal IFe, because the GaAsFET gain increases when the level of the incoming IF signal also increases, as visible in Fig.2 and inside the EXPAND block.

In the embodiment of the invention we chose to employ the same circuit configuration of Fig. 10, both to implement the level compression and expansion means, coinciding with COMPRES and EXPAND blocks, respectively. The expansion degree has to be optimized, in order to absolutely counterbalance the compression rate; therefore, an initial calibration of the gain of devices inside the two blocks is required. It is also convenient to render the system adaptive to neutralize the effects of deviations from the calibration point due to causes external to the devices tied to the operation conditions or to ageing. Among the external causes, the changed climatic conditions, for instance temperature and/or humidity variations concur. It results thus justified the presence of the feedback block AM/AM-CONTR of Fig. 7 according to the first embodiment. This block, optimizing the growth degree of the internal device gain, restores the original trend that the signal had at the output of the modulator MOD at the input of demodulator DEMOD. However, it must be underlined the fact that the embodiment is not strictly essential to the implementation of the invention, but it represents a useful additional "tool" that can perfect its operation emphasising the relevant advantages. In fact, the embodiment enables to maintain the trends of the compression functions and of level expansion functions in good agreement, both at starting and during the equipment life cycle. Hence, it is recommended either to correct the shape difference of the compression/expansion curves due to the particular devices employed for the compressor and the expander, or to correct the deviations due to the causes described above.

With reference to Fig.11 we can notice that the AM/AM-CONTR block includes: a logic block LOGIC-CONTR, a digital to analogue converter D/A, and an operational amplifier OPR. The CONTR-LOGIC block receives a signal indicative of the quality parameter PARqual coming from the demodulator DEMOD of Fig. 7. The CONTR-LOGIC block generates, matching the PARqual signal, a digital word corresponding to a VG value sent to the input of the D/A converter, which generates in turn an analogue voltage VG. The operational OPR has the + input connected to the ground and the - input connected to two resistances R6 and R7 having opportune value, of which R7 is feedback placed between the output and the input - of the operational OPR, in order that the same inverts the input voltage VG applied to the free end of R6. At the output of the operational OPR the voltage -VG is therefore present available to polarize the gate electrode of the GaAsFET of Fig. 10 included in the EXPAND block. In lack of the AM/AM-CONTR block according to the embodiment, the voltage -VG is kept constant and can be directly withdrawn from the +VD voltage through resistive divider.

The CONTR-LOGIC block can conveniently coincide with a microprocessor, however normally already present in transmission and reception systems adequate to include the present invention. An implementation of the CONTR-LOGIC block shall be described here after for briefness sake only for the case of the QAM modulation, the extension to AM modulation being obvious and immediate. In the QAM case it is useful to assume as parameter PARqual the so-called FEC (Forward Error Correction). The FEC signal is an impulse emitted by the demodulator at each correction of an error detected in received symbols. It must be underlined that the generation of an impulse does not mean that a symbol wrongly received generates also wrong data, but simply that an error in demodulated symbols has been detected and that the error has been corrected. The strategy implemented to optimize the expansion degree, is to act on the voltage -VG of the GaAsFET of Fig. 10 included in the EXPAND block, in co-ordinated manner with the rate of correction operations made by demodulator DEMOD. The CONTR-LOGIC block calculates the rate of correction operations counting the FEC impulses detected in a determined time slot, for instance one minute. Therefore, the above-mentioned block acts also as frequency-meter of FEC impulses. The rate of correction operations is then used as shown in the flow chart represented in the next Fig.12.

With reference to **Fig.12**, we can notice a flow chart outlining the operation of the LOGIC/CONTR block. In the flow-chart of Fig. 12, after the START, an initial phase F1 is performed, in which the microprocessor writes a nominal value VGnom in a record VG destined to contain the VG word outgoing towards the D/A converter; in the same phase a record RFEC destined to contain the rate of correction operations calculated within the predetermined count time of FEC impulses is also reset. The subsequent phase F2 corresponds to the contribution of an increase $|\Delta VG|$ to digital voltage VG (the module indication means an always positive $\Delta VG$ value, as positive is also the value of the digital voltage VG). During phase F3 the microprocessor calculates the rate of correction operations RFEC(T+1) at the subsequent predetermined time T+1, and in phase F4 performs a test on the new rate RFEC(T+1) to see if it decreased or remained unchanged versus the previous value. In the case the response is affirmative, phase F5 is performed in which the new value of the rate RFEC(T+1) replaces the one previously stored RFEC(T) before the repetition of the cycle made of the phases F2, F3, F4 and F5. If in the interrogation phase F4 the response is negative, it means that the sense of correction is not the more opportune; in this case it is necessary to run a decrease cycle of the digital voltage VG consisting of phases F6, F7, F8 and F9 similar to those of the previous cycle. More in particular, in phase F6 the VG digital voltage of a |ΔVG| value identical to that of phase F2 is decreased. During phase F7 the microprocessor calculates the rate of correction operations RFEC(T+1) at the subsequent predetermined time, and in phase F8 performs a test on the new rate RFEC(T+1) to see if it decreased or remained unchanged versus the previous value. Should the response be affirmative, phase F9 is performed, in which the new rate value RFEC(T+1) replaces the one previously stored (T) before the repetition of the cycle consisting of phases F6, F7, F8 and F9. If in the query phase F8 the response is negative, it means that the sense of the correction is not the opportune one, in this case it is necessary to return to phase F2 to try again a correction of the digital voltage VG in opposite direction.

The microprocessor performs the flow chart of Fig.12 for an indefinite time reciprocally alternating the two correction cycles. Even if not expressly indicated in the figure, a RESET control may at any moment bring the operation to VG and FEC nominal values of phase F1. The sector technician, by attempts and corrections, easily succeeds in adjusting the best value of the increase |ΔVG| and the duration of the count of FEC impulses that influence at some extent one another.

The operation of the CONTR-LOGIC block for the case of AM modulations can be obtained writing the value of the selected quality parameter PARqual in the record RFEC of Fig. 12. To this purpose, the ratio between the peak value and the average value of the AM signal can be measured within a predetermined time slot and therefore the value measured can be compared with the value of said ratio obtained through statistical evaluations relevant to the type of transmitted signal, the difference representing the above-mentioned quality parameter PARqual.

The fact to have realized the COMPRES and EXPAND blocks at intermediate frequency represents an undoubted advantage, however this does not limit the invention as to the possibility to supply the above-mentioned blocks with the modulated signal in base band. This opportunity, which for briefness sake was not shown in the figures of the embodiments, having preferred to indicate the modulated signal directly at intermediate frequency IF, is actually compulsorily pursuable when the operation speed of the A/D and D/A converters excludes its use at intermediate frequency.

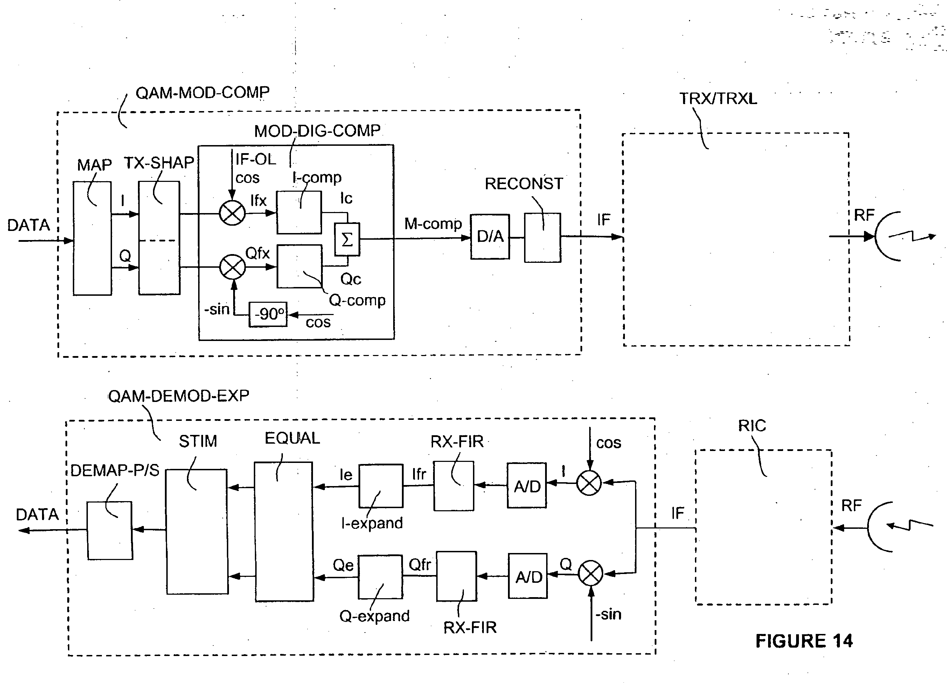

With reference to **Fig.14** the second embodiment is now described and it applies to the sole modulated signals QAM. As it can be noticed, the transmission and reception system shown in Fig.14 differs from that of Fig. 7 (valid both for QAM and AM signals) due to the fact that the COMPRES and EXPAND blocks of Fig. 7 are missing and the modulation and demodulation blocks do no more correspond to the known implementations for the QAM case, respectively indicated in Fig.6 with QAM-MOD and QAM-DEMOD; while TRX (or TRXL of Fig. 13) and RIC blocks are the same. In **Fig.14** a QAM-MOD-COMP block and a QAM-DEMOD-EXP block indicate a QAM modulator and a QAM demodulator, respectively, belonging to the second embodiment. The QAM-MOD-COMP modulator differs from the QAM-MOD modulator of Fig. 6 only in that it includes a MOD-DIG block-COMP representing a digital modulator different from the similar MOD-DIG block of Fig. 6 and in that it includes two digital compression blocks I-comp and Q-comp bridging the I and Q ways, immediately before the relevant inputs of the digital adder Σ. From the two sections of the TX-SHAP filter, Ifx and Qfx components come out and the same are converted to IF and sent to I-comp and Q-comp blocks respectively, that in turn generate at output some Ic, Qc components. The latter reach the adder Σ inputs, from which a signal M-comp of the QAM compressed in the amplitude dynamic type comes out. The QAM-DEMOD-EXP demodulator differs from the QAM-DEMOD demodulator of Fig. 6 due to the sole fact to include an I-expand block and a Q-expand digital expansion block bridging the I and Q ways, immediately after the output of digital filters RX-FIR. The I-expand and Q-expand blocks receive some relevant Ifr and Qfr components filtered by filters RX-FIR, and in turn generate at output some relevant Ie, Qe components reaching the inputs of the EQUAL block.

In the operation, the pairs of I-comp, Q-comp and I-expand, Q-expand blocks calculate the components of the modulation vectors V1 and V2 of Fig. **15**. These blocks are conveniently implemented with read-only programmable memories (PROM), used as look-up tables addressed by the I/Q components of the original signal for the reading of the desired Ic, Qc, Ie, Qe components. The Ic, Qc, Ie, Qe values written in the PROM are those calculated applying the desired compression/expansion law to the module R of the modulation vector representing the signal to compress/expand. This vector in the case of compression, is the one defined by the Ifx and Qfx components, while in the expansion case, it is that defined by the Ifr and Qfr components. Filters TX-SHAP and RX-FIR do not alter the phase of the input vector.

Recalling what said before, the compression law can be represented through a function $Gcp(x)$. Denoted $Rcp = Gcp(R)$ (2) the vector module representing the compressed signal QAM, and recalling the known relations: $I = R \cos\theta$ and $Q = R\sin\theta$, it results that the Ic, Qc components concerning the points of the distorted constellation due to the compression are calculated applying the following relations: $Ic = Rcp \cos \theta$; $Qc = Rcp \sin\theta$, where the $Rcp$, values are known from the (2) calculated in points $(R,\theta)$ of the original constellation, from which we observe that phase $\theta$ remains unchanged. The Ic, Qc components are those of the compressed modulation vector denoted with M-comp having module

$$Rcp = \sqrt{Ic^2 + Qc^2} \quad (3).$$

The expansion law can be represented through a function Gex(x). Let $x = Rcp$, being $Rcp$ the vector representing the signal received IF, the expansion function shall have a trend $Gex(Rcp)$ calculated in the points of the distorted constellation. Denoted Re $x = Gex(Rcp)$ (4) the module of the vector that suffered the expansion, it results that the Ie,

Qe components concerning the points of the expanded constellation, are calculated applying the following relations: *Ie* = Re *x* cosθ; *Qe* = Re *x sin θ*, where the values of module Re*x* are known from the (4) calculated in points (*Rcp*,θ) of the expanded constellation. The phase θ remains unchanged. Remembering what said on the shape restriction that ties the *Gcp*(*x*) and *Gex*(*x*) functions, the combined effect of the two functions involves the following:

$$\text{Re}\,x = Gex(Rcp) = Gex(Gcp(R)) = R \qquad\qquad (5)$$

which shows the recovery of the original constellation through the expansion of the compressed constellation.

The introduction of function (2) determines an increase of the potential points to consider on the plan of the phases versus the points of the original constellation. Longer digital words are therefore necessary for the writing of the modified components Ic, Qc, Ie, Qe compared to those sufficient to contain the original I/Q components. Limited to QAM modulations, the approach of the second embodiment offers higher freedom concerning the synthesis of the compression/expansion function shape, versus the opportunities previously described. However, deciding for what previously said, to summarize the shape of the compression/expansion curve of amplification devices contained in the COMP and EXPAND blocks of Fig. 7, it is now possible to better calibrate, for instance, the point in which the trend deviates from the initial length potentially constant and the slope steepness. The trend of functions *Gcp*(*x*) and *Gex*(*x*) in the interval of values having practical meaning can be obtained as already said in the introduction.

A further advantage of the second embodiment is to render unessential the optimization of expansion thanks to the digital implementation of the compression and expansion means.

While a particular embodiment of the invention has been shown and described, it should be understood that the present invention is not limited thereto since other embodiments may be made by those skilled in the art without departing from the scope thereof. In particular the compression and the expansion law of said modulated transmission signal are obtained, according to the invention, by means of analog means, e.g. by adjusting the operating point of analog amplifiers. According to a different embodiment of the invention said expansion and compression law are obtained by means of digital means, e.g. by altering the transfer characteristics of a digital modulator and demodulator. It is thus contemplated that the present invention encompasses any and all such embodiments covered by the following claims.

## Claims

1. Radiofrequency transmission and reception method of amplitude modulated (SAN), or amplitude and phase modulated signals (Ifx, Qfx) from digital data (DATI) according to a scheme known as QAM, each said modulated signal having a wide amplitude dynamic in the modulation envelope and being therefore capable of saturating the gain of radiofrequency final power amplifier devices on the power peaks of said envelope and therefore suffer amplitude and phase distortions, **characterized in that** it includes the following steps:

   - compress the amplitude (COMPRES, IFc) of a said modulated transmission signal (IF), without altering the phase, according to the amplitude of said modulated transmission signal (IF) and according to a compression law having a first constant portion and then decreasing as the amplitude increases;
   - expand the amplitude (EXPAND, IFe) of a said modulated reception signal (IF) without altering the phase, according to the amplitude of said modulated reception signal (IF) and according to an expansion law which has the opposite trend of said compression law.

2. Radiofrequency transmission and reception method according to claim 1, **characterized in that** said compression and expansion laws are obtained by adjusting the operating point of analog amplifiers (COMPRES).

3. Radiofrequency transmission and reception method according to claim 1, **characterized in that** said compression and expansion laws are obtained by digitally altering the transfer characteristics of a digital modulator (QAM-MOD-COMP) and demodulator (QAM-DEMOD-EXP).

4. Radiofrequency transmission and reception method according to claim 2, **characterized in that** said compression law has trend similar to that of the power gain of said radiofrequency power amplifier devices (PW-AMP, GaAsFET) evaluated at the centre -band frequency of the amplified signal (RF).

5. Radiofrequency transmission and reception method according to claim 1 or 2, **characterized in that** said expansion (EXPAND) is recursively corrected on the basis of the measurement of a parameter indicating the quality (PARqual) of the demodulated signal (DATI, $S_{AN}$), under the condition to improve said quality.

6.  Radiofrequency transmission and reception method according to claim 1, **characterized in that** it includes the following steps:

    - representation of a QAM modulated signal by means of a modulation vector (V2) moving during the transmission among the symbols (SY2) of a constellation, the modulated signal being able to saturate the gain of the radiofrequency final power amplifier devices (PW-AMP) on power peaks of the modulation envelope;
    - modulation and generation of a distorted constellation by replacement of distal symbols (SY2) of the original constellation by new symbols (SY1) closer to the centre of the same, the distorted constellation attenuating said power peaks in transmission; and the new symbols (SY1) being obtained by said compression law applied to the module of said modulation vector (V2) without altering the phase;
    - restoration of symbols (SY2) of the original constellation on the basis of symbols (SY1) of the distorted constellation, the restored symbols (SY2) being obtained applying the reciprocal of said compression law to the module of vector (Ifr, Qfr) representing the demodulated reception signal (IF), so to expand the module without altering the phase;
    - estimation (STIM) of demodulated data (DATI) on the basis of symbols (Ie, Qe) of the restored constellation.

7.  Transmission and reception method a radiofrequency according to any one of the previous claims, **characterized in that** said compression (COMPRES) and said expansion (EXPAND) are carried out at intermediate frequency (IF).

8.  Radiofrequency transmission and reception method according to any one of claims 1 to 7, **characterized in that** said compression (COMPRES) and said expansion (EXPAND) are carried out in base band.

9.  Radiofrequency transmission and reception method according to any one of the previous claims, **characterized in that** in transmission the signal subjected to said compression is additionally subjected to a pre-distortion of the amplitude dynamic and of the phase (LINEARIZ) before being sent to said radiofrequency final power amplifier device (PW-AMP, GaAsFET), the extent of the pre-distortion of the amplitude and phase dynamic according to the power of the signal to pre-distort (RF) being such to compensate said amplitude and phase distortions introduced by said amplifier device.

10. Radiofrequency transmission and reception system of amplitude modulated (SAN), or amplitude and phase modulated signals (Ifx, Qfx) from digital data (DATI) according to a scheme known as QAM, each modulated signal having a wide amplitude dynamic in the modulation envelope and therefore being able to saturate the gain of radiofrequency final power amplifier devices on the power peaks of said envelope, therefore suffering amplitude and phase distortions, **characterized in that** it includes:

    - compression means (COMPRESS, Icomp, Qcomp) of the amplitude dynamic of the transmission modulated signal (IF) placed downstream a modulator (MOD), said compression means configured to operate according to a compression law having a first constant portion and then decreasing as the amplitude increases;
    - expansion means (EXPAND, Iexpand, Qexpand) of the amplitude dynamic of the modulated reception signal (IF) placed upstream a demodulator (DEMOD), said expansion means configured to operate according to an expansion law which is the reciprocal of said compression law.

11. Radiofrequency transmission and reception system according to claim 10, **characterized in that** said compression and expansion means are of the analog type (COMPRESS, EXPAND) and are obtained by adjusting the operating point of analog amplifiers.

12. Radiofrequency transmission and reception system according to claim 10 **characterized in that** said compression and expansion means are of the digital type (Iexpand, Qexpand) and are obtained by digitally altering the characteristics of a digital modulator and demodulator.

13. Transmission and reception system according to claim 10, **characterized in that** said compression law has trend similar to the trend of the power gain of said radiofrequency power amplifiers (PW-AMP, GaAsFET) evaluated at the centre-band frequency of the amplified signal (RF).

14. Transmission and reception system according to claim 11, **characterized in that** said analogue compression means (COMPRES) include a radiofrequency amplifier transistor (GaAsFET) polarized close to the knee area of the power transfer function.

15. Transmission and reception system according to claim 11, **characterized in that** said analogue expansion means (EXPAND) consist of a radiofrequency transistor amplifier (GaAsFET) polarized close to the pinch-off area of the power transfer function.

16. Transmission and reception system according to any one of claim 10 to 15, **characterized in that** it also includes correction means (AM/AM-CONTR) of said expansion acting in feedback between said demodulator (QAM-DEMOD) and said expansion means (EXPAND) on the basis of a measure of a parameter indicative of the quality (PARqual) of the demodulated signal, under the condition to improve said quality.

17. Radiofrequency transmission and reception system according to claim 10, **characterized in that** it includes:

    - means (MOD-DIG-COMP) for representing a QAM modulated signal by means of a modulation vector moving during the transmission among the symbols (SY2) of a constellation, the modulated signal being able to saturate the gain of radiofrequency final power amplifier devices (PW-AMP) on power peaks of the modulation envelope;
    - means (Icomp, Qcomp) of modulation and generation of a distorted constellation operating a replacement of distal symbols (SY2) of the original constellation by new symbols (SY1) closer to the centre of the same, the distorted constellation attenuating said power peaks in transmission, and the new symbols (SY1) being obtained by said compression law applied to the module of said modulation vector (V2) without altering the phase;
    - means (QAM-DEMOD-EXP) to restore symbols (SY2) of the original constellation on the basis of symbols (SY1) of the distorted constellation, the restored symbols (SY2) being obtained applying the reciprocal of said compression law to the module of vector (Ifr, Qfr) representing the demodulated reception signal (Ifr, Qfr) of the restored constellation, so to expand the module without altering the phase;
    - means to estimate (STIM) of data transmitted (DATI) on the basis of the symbols (Ie, Qe) of the restored constellation.

18. Transmission and reception system according to any claim 10 to 17, **characterized in that** said compression means (COMPRES) and said expansion means (EXPAND) operate at intermediate frequency (IF).

19. Transmission and reception system according to any claim 10 to 17, **characterized in that** said compression means (COMPRES) and said expansion means (EXPAND) operate in base band.

20. Transmission and reception system according to any claim 10 to 19, **characterized in that** it additionally includes an analogue pre-distorter of the level dynamic and of the phase (LINEARIZ) of the transmission signal (RF) placed between the compression means (COMPRES) and said radiofrequency final power amplifier device (PW-AMP, GaAsFET), the extent of the level dynamic and of the phase pre-distortion according to the power of the signal to pre-distort (RF) such to compensate aid amplitude and phase distortions introduced by said amplifier device.

## Patentansprüche

1. Hochfrequenzsende- und -empfangsverfahren amplitudenmodulierter (SAN) oder amplituden- und phasenmodulierter Signale (Ifx, Qfx) aus digitalen Daten (DATI) gemäß einem Schema, das als QAM bekannt ist, wobei jedes modulierte Signal eine große Amplitudendynamik in der Modulations-Hüllkurve aufweist und daher die Verstärkung des Hochfrequenz-Leistungsendverstärkers auf den Leistungsspitzen der Hüllkurve sättigen und daher Amplituden- und Phasenverzerrungen erfahren kann, **dadurch gekennzeichnet, dass** das Verfahren die folgenden Schritte umfasst:

    - Komprimieren der Amplitude (COMPRES, IFc) des modulierten Sendesignals (IF) ohne Ändern der Phase gemäß der Amplitude des modulierten Sendesignals (IF) und gemäß einer Komprimierungsregel, die einen ersten konstanten Abschnitt aufweist und dann abnimmt, wenn die Amplitude zunimmt;
    - Erweitern der Amplitude (EXPAND, IFe) des modulierten Empfangssignals (IF) ohne Ändern der Phase gemäß der Amplitude des modulierten Empfangssignals (IF) und gemäß einer Erweiterungsregel, die eine der Komprimierungsregel entgegengesetzte Tendenz aufweist.

2. Hochfrequenzsende- und -empfangsverfahren nach Anspruch 1, **dadurch gekennzeichnet, dass** die Komprimierungs- und Erweiterungsregel durch Anpassen des Arbeitspunkts analoger Verstärker (COMPRES) erhalten werden.

3. Hochfrequenzsende- und -empfangsverfahren nach Anspruch 1, **dadurch gekennzeichnet, dass** die Komprimierungs- und Erweiterungsregel durch digitales Ändern der Übertragungskennlinien eines digitalen Modulators (QAM-MOD-COMP) und Demodulators (QAM-DEMOD-EXP) erhalten werden.

4. Hochfrequenzsende- und -empfangsverfahren nach Anspruch 2, **dadurch gekennzeichnet, dass** die Komprimierungsregel eine Tendenz aufweist, die ähnlich jener der Leistungsverstärkung der Hochfrequenzleistungsverstärkungsvorrichtungen (PW-AMP, GaAsFET) ist, die bei der Frequenz des mittleren Bandes des verstärkten Signals (RF) bewertet wird.

5. Hochfrequenzsende- und -empfangsverfahren nach Anspruch 1 oder 2, **dadurch gekennzeichnet, dass** die Ausweitung (EXPAND) auf der Basis der Messung eines Parameters, der die Qualität (PARqual) des demodulierten Signals (DATI, $S_{AN}$) angibt, unter der Bedingung, dass die Qualität verbessert wird, rekursiv korrigiert wird.

6. Hochfrequenzsende- und -empfangsverfahren nach Anspruch 1, **dadurch gekennzeichnet, dass** es die folgenden Schritte umfasst:

   - Darstellen eines QAM-modulierten Signals mit Hilfe eines Modulationsvektors (V2), der sich während des Sendens unter den Symbolen (SY2) einer Konstellation bewegt, wobei das modulierte Signal die Verstärkung der Hochfrequenz-Leistungsendverstärkervorrichtungen (PW-AMP) auf Leistungsspitzen der Modulations-Hüllkurve sättigen kann;
   - Modulieren und Erzeugen einer verzerrten Konstellation durch Ersetzen distaler Symbole (SY2) der ursprünglichen Konstellation durch neue Symbole (SY1), die näher bei deren Mitte sind, wobei die verzerrte Konstellation die Leistungsspitzen beim Senden dämpft; und wobei die neuen Symbole (SY1) durch die Komprimierungsregel, die auf den Betrag des Modulationsvektors (V2) ohne Ändern der Phase angewendet wird, erhalten werden;
   - Wiederherstellen von Symbolen (SY2) der ursprünglichen Konstellation auf der Basis von Symbolen (SY1) der verzerrten Konstellation, wobei die wiederhergestellten Symbole (SY2) durch Anwenden der Umkehrung der Komprimierungsregel auf den Betrag des Vektors (Ifr, Qfr), der das demodulierte Empfangssignal (IF) darstellt, um den Betrag ohne Ändern der Phase auszuweiten, erhalten werden;
   - Schätzen (STIM) von demodulierten Daten (DATI) auf der Basis von Symbolen (Ie, Qe) der wiederhergestellten Konstellation.

7. Sende- und Empfangsverfahren einer Hochfrequenz nach einem der vorhergehenden Ansprüche, **dadurch gekennzeichnet, dass** die Komprimierung (COMPRES) und die Erweiterung (EXPAND) bei einer Zwischenfrequenz (IF) ausgeführt werden.

8. Hochfrequenzsende- und -empfangsverfahren nach einem der Ansprüche 1 bis 7, **dadurch gekennzeichnet, dass** die Komprimierung (COMPRES) und die Erweiterung (EXPAND) im Grundband ausgeführt werden.

9. Hochfrequenzsende- und -empfangsverfahren nach einem der vorhergehenden Ansprüche, **dadurch gekennzeichnet, dass** beim Senden das Signal, das der Komprimierung unterworfen ist, zusätzlich einer Vorverzerrung der Amplitudendynamik und der Phase (LINEARIZ) unterworfen wird, bevor es zu der Hochfrequenz-Leistungsendverstärkervorrichtung (PW-AMP, GaAsFET) gesendet wird, wobei der Grad der Vorverzerrung der Amplituden- und Phasendynamik gemäß der Leistung des Signals, das vorverzerrt werden soll (RF), derart ist, dass die Amplituden- und Phasenverzerrungen, die durch die Verstärkervorrichtung eingeführt werden, kompensiert werden.

10. Hochfrequenzsende- und Empfangssystem von amplitudenmodulierten (SAN) oder amplituden- und phasenmodulierten Signalen (Ifx, Qfx) aus digitalen Daten (DATI) gemäß einem Schema, das als QAM bekannt ist, wobei jedes modulierte Signal eine große Amplitudendynamik in der Modulations-Hüllkurve aufweist und daher die Verstärkung des Hochfrequenz-Leistungsendverstärkers auf den Leistungsspitzen der Hüllkurve sättigen kann und daher Amplituden- und Phasenverzerrungen erfährt, **dadurch gekennzeichnet, dass** das System Folgendes umfasst:

    - Komprimierungsmittel (COMPRESS, Icomp, Qcomp) der Amplitudendynamik des modulierten Sendesignals (IF), die einem Modulator (MOD) nachgeschaltet sind, wobei die Komprimierungsmittel konfiguriert sind, gemäß einer Komprimierungsregel, die einen ersten konstanten Abschnitt aufweist und dann abnimmt, wenn die Amplitude zunimmt, zu arbeiten;
    - Erweiterungsmittel (EXPAND, Iexpand, Qexpand) der Amplitudendynamik des modulierten Empfangssignals (IF), die einem Demodulator (DEMOD) vorgeschaltet sind, wobei die Erweiterungsmittel konfiguriert sind, gemäß einer Erweiterungsregel, die die Umkehrung der Komprimierungsregel ist, zu arbeiten.

**11.** Hochfrequenzsende- und Empfangssystem nach Anspruch 10, **dadurch gekennzeichnet, dass** die Komprimierungs- und Erweiterungsmittel vom analogen Typ sind (COMPRESS, EXPAND) und durch Anpassen des Arbeitspunkts analoger Verstärker erhalten werden.

**12.** Hochfrequenzsende- und Empfangssystem nach Anspruch 10, **dadurch gekennzeichnet, dass** die Komprimierungs- und Erweiterungsmittel vom digitalen Typ sind (Iexpand, Qexpand) und durch digitales Verändern der Kennlinien eines digitalen Modulators und Demodulators erhalten werden.

**13.** Sende- und Empfangssystem nach Anspruch 10, **dadurch gekennzeichnet, dass** die Komprimierungsregel eine Tendenz aufweist, die ähnlich der Tendenz der Leistungsverstärkung der Hochfrequenzleistungsverstärker (PW-AMP, GaAsFET) ist, die an der Frequenz des mittleren Bandes des verstärkten Signals (RF) bewertet wird.

**14.** Sende- und Empfangssystem nach Anspruch 11, **dadurch gekennzeichnet, dass** die analogen Komprimierungsmittel (COMPRES) einen Hochfrequenzverstärkertransistor (GaAsFET) enthalten, der nahe dem Kniebereich der Leistungsübertragungsfunktion polarisiert ist.

**15.** Sende- und Empfangssystem nach Anspruch 11, **dadurch gekennzeichnet, dass** die analogen Erweiterungsmittel (EXPAND) aus einem Hochfrequenztransistorverstärker (GaAsFET) bestehen, der nahe dem Abschnürbereich der Leistungsübertragungsfunktion polarisiert ist.

**16.** Sende- und Empfangssystem nach einem der Ansprüche 10 bis 15, **dadurch gekennzeichnet, dass** es außerdem Korrekturmittel (AM/AM-CONTR) der Erweiterung enthält, die in Rückkopplung zwischen dem Demodulator (QAM-DEMOD) und den Erweiterungsmitteln (EXPAND) auf der Basis einer Messung eines Parameters, der die Qualität (PARqual) des demodulierten Signals angibt, unter der Bedingung, das die Qualität verbessert wird, arbeiten.

**17.** Hochfrequenzsende-und Empfangssystem nach Anspruch 10, **dadurch gekennzeichnet, dass** es Folgendes enthält:

- Mittel (MOD-DIG-COMP) zum Darstellen eines QAM-modulierten Signals mit Hilfe eines Modulationsvektors, der sich während des Sendens unter Symbolen (SY2) einer Konstellation bewegt, wobei das modulierte Signal die Verstärkung der Hochfrequenz-Leistungsendverstärkervorrichtungen (PW-AMP) auf Leistungsspitzen der Modulations-Hüllkurve sättigen kann;
- Mittel (Icomp, Qcomp) zum Modulieren und Erzeugen einer verzerrten Konstellation, die eine Ersetzung distaler Symbole (SY2) der ursprünglichen Konstellation durch neue Symbole (SY1), die näher dessen Zentrum sind, ausführen, wobei die verzerrte Konstellation die Leistungsspitzen beim Senden dämpft und wobei die neuen Symbole (SY1) durch die Komprimierungsregel, die auf den Betrag des Modulationsvektors (V2) angewendet wird, ohne die Phase zu ändern, erhalten werden;
- Mittel (QAM-DEMOD-EXP) zum Wiederherstellen von Symbolen (SY2) der ursprünglichen Konstellation auf der Basis von Symbolen (SY1) der verzerrten Konstellation, wobei die wiederhergestellten Symbole (SY2) durch Anwenden der Umkehrung der Komprimierungsregel auf den Betrag des Vektors (Ifr, Qfr), der das demodulierte Empfangssignal (IF) der wiederhergestellten Konstellation darstellt, um den Betrag ohne Ändern der Phase auszuweiten, erhalten werden;
- Mittel zum Schätzen (STIM) der gesendeten Daten (DATI) auf der Basis der Symbole (Ie, Qe) der wiederhergestellten Konstellation.

**18.** Sende- und Empfangssystem nach einem der Ansprüche 10 bis 17, **dadurch gekennzeichnet, dass** die Komprimierungsmittel (COMPRES) und die Erweiterungsmittel (EXPAND) an einer Zwischenfrequenz (IF) arbeiten.

**19.** Sende- und Empfangssystem nach einem der Ansprüche 10 bis 17, **dadurch gekennzeichnet, dass** die Komprimierungsmittel (COMPRES) und die Erweiterungsmittel (EXPAND) im Grundband arbeiten.

**20.** Sende- und Empfangssystem nach einem der Ansprüche 10 bis 19, **dadurch gekennzeichnet, dass** es zusätzlich einen analogen Vorverzerrer der Pegeldynamik und der Phase (LINEARIZ) des Sendesignals (RF) enthält, der zwischen den Komprimierungsmitteln (COMPRES) und der Hochfrequenz-Leistungsendverstärkervorrichtung (PW-AMP, GaAsFET) angeordnet ist, wobei der Grad der Vorverzerrung der Pegeldynamik und der Phase gemäß der Leistung des Signals, das vorverzerrt werden soll (RF), derart ist, dass er die Amplituden- und Phasenverzerrung, die durch die Verstärkervorrichtung eingeführt wird, kompensiert.

**Revendications**

1. Un procédé d'émission et de réception radioélectrique de signaux à modulation d'amplitude (SAN) ou de signaux à modulation de phase et d'amplitude (Ifx, Qfx) à partir de données numériques (DATI) selon un mécanisme connu sous le nom de QAM, chacun desdits signaux modulés possédant une large dynamique d'amplitude dans l'enveloppe de modulation et étant en conséquence capable de saturer le gain de dispositifs amplificateurs de puissance finaux radioélectriques sur les pics de puissance de ladite enveloppe et en conséquence subir des distorsions de phase et d'amplitude, **caractérisé en ce qu'**il comprend les étapes suivantes :

   - la compression de l'amplitude (COMPRES, IFc) d'un dit signal d'émission modulé (IF), sans altérer la phase, en fonction de l'amplitude dudit signal d'émission modulé (IF) et en fonction d'une loi de compression possédant une première partie constante et ensuite décroissante à mesure que l'amplitude augmente,
   - l'expansion de l'amplitude (EXPAND, IFe) d'un dit signal de réception modulé (IF) sans altérer la phase, en fonction de l'amplitude dudit signal de réception modulé (IF) et en fonction d'une loi d'expansion qui présente la tendance opposée de ladite loi de compression.

2. Le procédé d'émission et de réception radioélectrique selon la revendication 1, **caractérisé en ce que** lesdites lois de compression et d'expansion sont obtenues par le réglage du point de fonctionnement d'amplificateurs analogiques (COMPRES).

3. Le procédé d'émission et de réception radioélectrique selon la revendication 1, **caractérisé en ce que** lesdites lois de compression et d'expansion sont obtenues par une altération numérique des caractéristiques de transfert d'un modulateur (QAM-MOD-COMP) et d'un démodulateur (QAM-DEMOD-EXP) numériques.

4. Le procédé d'émission et de réception radioélectrique selon la revendication 2, **caractérisé en ce que** ladite loi de compression présente une tendance similaire à celle du gain de puissance desdits dispositifs amplificateurs de puissance radioélectrique (PW-AMP, GaAsFET) évalué au niveau de la fréquence centrale de la bande du signal amplifié (RF).

5. Le procédé d'émission et de réception radioélectrique selon la revendication 1 ou 2, **caractérisé en ce que** ladite expansion (EXPAND) est corrigée de manière récursive sur la base de la mesure d'un paramètre indiquant la qualité (PARqual) du signal démodulé (DATI, $S_{AN}$), à la condition d'améliorer ladite qualité.

6. Le procédé d'émission et de réception radioélectrique selon la revendication 1, **caractérisé en ce qu'**il comprend les étapes suivantes :

   - la représentation d'un signal modulé QAM au moyen d'un vecteur de modulation (V2) se déplaçant au cours de l'émission parmi les symboles (SY2) d'une constellation, le signal modulé étant capable de saturer le gain des dispositifs amplificateurs de puissance finaux radioélectriques (PW-AMP) sur des pics de puissance de l'enveloppe de modulation,
   - la modulation et la génération d'une constellation distordue par le remplacement de symboles distaux (SY2) de la constellation d'origine par de nouveaux symboles (SY1) plus proches du centre de celle-ci, la constellation distordue atténuant lesdits pics de puissance en émission, et les nouveaux symboles (SY1) étant obtenus par ladite loi de compression appliquée au module dudit vecteur de modulation (V2) sans altérer la phase,
   - la restauration de symboles (SY2) de la constellation d'origine sur la base de symboles (SY1) de la constellation distordue, les symboles restaurés (SY2) étant obtenus par l'application de la réciproque de ladite loi de compression au module de vecteur (Ifr, Qfr) représentant le signal de réception démodulé (IF), de façon à étendre le module sans altérer la phase,
   - l'estimation (STIM) de données démodulées (DATI) sur la base de symboles (Ie, Qe) de la constellation restaurée.

7. Le procédé d'émission et de réception radioélectrique selon l'une quelconque des revendications précédentes, **caractérisé en ce que** ladite compression (COMPRES) et ladite expansion (EXPAND) sont réalisées à une fréquence intermédiaire (IF).

8. Le procédé d'émission et de réception radioélectrique selon l'une quelconque des revendications 1 à 7, **caractérisé en ce que** ladite compression (COMPRES) et ladite expansion (EXPAND) sont réalisées en bande de base.

**EP 1 164 694 B1**

9. Le procédé d'émission et de réception radioélectrique selon l'une quelconque des revendications précédentes, **caractérisé en ce que**, en émission, le signal soumis à ladite compression est en outre soumis à une prédistorsion de la dynamique d'amplitude et de la phase (LINEARIZ) avant d'être envoyé audit dispositif amplificateur de puissance final radioélectrique (PW-AMP, GaAsFET), l'étendue de la prédistorsion de la dynamique de phase et d'amplitude en fonction de la puissance du signal à prédistordre (RF) étant telle qu'elle compense lesdites distorsions de phase et d'amplitude introduites par ledit dispositif amplificateur.

10. Un système d'émission et de réception radioélectrique de signaux à modulation d'amplitude (SAN) ou de signaux à modulation de phase et d'amplitude (Ifx, Qfx) à partir de données numériques (DATI) selon un mécanisme connu sous le nom de QAM, chaque signal modulé possédant une large dynamique d'amplitude dans l'enveloppe de modulation et en conséquence étant capable de saturer le gain de dispositifs amplificateurs de puissance finaux radioélectriques sur les pics de puissance de ladite enveloppe, subissant en conséquence des distorsions de phase et d'amplitude, **caractérisé en ce qu'**il comprend :

- un moyen de compression (COMPRESS, Icomp, Qcomp) de la dynamique d'amplitude du signal modulé d'émission (IF) placé en aval d'un modulateur (MOD), ledit moyen de compression étant configuré de façon à fonctionner en fonction d'une loi de compression possédant une première partie constante et ensuite décroissante à mesure que l'amplitude augmente,
- un moyen d'expansion (EXPAND, Iexpand, Qexpand) de la dynamique d'amplitude du signal de réception modulé (IF) placé en amont d'un démodulateur (DEMOD), ledit moyen d'expansion étant configuré de façon à fonctionner en fonction d'une loi d'expansion qui est la réciproque de ladite loi de compression.

11. Le système d'émission et de réception radioélectrique selon la revendication 10, **caractérisé en ce que** lesdits moyens de compression et d'expansion sont du type analogique (COMPRESS, EXPAND) et sont obtenus par le réglage du point de fonctionnement d'amplificateurs analogiques.

12. Le système d'émission et de réception radioélectrique selon la revendication 10 **caractérisé en ce que** lesdits moyens de compression et d'expansion sont du type numérique (Iexpand, Qexpand) et sont obtenus par une altération numérique des caractéristiques d'un modulateur et d'un démodulateur numériques.

13. Le système d'émission et de réception selon la revendication 10, **caractérisé en ce que** ladite loi de compression présente une tendance similaire à la tendance du gain de puissance desdits amplificateurs de puissance radioélectriques (PW-AMP, GaAsFET) évalué au niveau de la fréquence centrale de la bande du signal amplifié (RF).

14. Le système d'émission et de réception selon la revendication 11, **caractérisé en ce que** ledit moyen de compression analogique (COMPRES) comprend un amplificateur à transistors radioélectrique (GaAsFET) polarisé à proximité de la zone de genou de la fonction de transfert de puissance.

15. Le système d'émission et de réception selon la revendication 11, **caractérisé en ce que** ledit moyen d'expansion analogique (EXPAND) se compose d'un amplificateur à transistors radioélectrique (GaAsFET) polarisé à proximité de la zone de pincement de la fonction de transfert de puissance.

16. Le système d'émission et de réception selon l'une quelconque des revendications 10 à 15, **caractérisé en ce qu'**il comprend également un moyen de correction (AM/AM-CONTR) de ladite expansion agissant en rétroaction entre ledit démodulateur (QAM-DEMOD) et ledit moyen d'expansion (EXPAND) sur la base d'une mesure d'un paramètre indicatif de la qualité (PARqual) du signal démodulé, à la condition d'améliorer ladite qualité.

17. Le système d'émission et de réception radioélectrique selon la revendication 10, **caractérisé en ce qu'**il comprend :

- un moyen (MOD-DIG-COMP) de représentation d'un signal modulé QAM au moyen d'un vecteur de modulation se déplaçant au cours de l'émission parmi les symboles (SY2) d'une constellation, le signal modulé étant capable de saturer le gain de dispositifs amplificateurs de puissance finaux radioélectriques (PW-AMP) sur des pics de puissance de l'enveloppe de modulation,
- un moyen (Icomp, Qcomp) de modulation et de génération d'une constellation distordue effectuant un remplacement de symboles distaux (SY2) de la constellation d'origine par de nouveaux symboles (SY1) plus proches du centre de celle-ci, la constellation distordue atténuant lesdits pics de puissance en émission, et les nouveaux symboles (SY1) étant obtenus par ladite loi de compression appliquée au module dudit vecteur de modulation (V2) sans altérer la phase,

- un moyen (QAM-DEMOD-EXP) de restauration de symboles (SY2) de la constellation d'origine sur la base de symboles (SY1) de la constellation distordue, les symboles restaurés (SY2) étant obtenus par l'application de la réciproque de ladite loi de compression au module de vecteur (Ifr, Qfr) représentant le signal de réception démodulé (Ifr, Qfr) de la constellation restaurée, de façon à étendre le module sans altérer la phase,
- un moyen d'estimation (STIM) de données émises (DATI) sur la base des symboles (Ie, Qe) de la constellation restaurée.

18. Le système d'émission et de réception selon l'une quelconque des revendications 10 à 17, **caractérisé en ce que** ledit moyen de compression (COMPRES) et ledit moyen d'expansion (EXPAND) fonctionnent à une fréquence intermédiaire (IF).

19. Le système d'émission et de réception selon l'une quelconque des revendications 10 à 17, **caractérisé en ce que** ledit moyen de compression (COMPRES) et ledit moyen d'expansion (EXPAND) fonctionnent en bande de base.

20. Le système d'émission et de réception selon l'une quelconque des revendications 10 à 19, **caractérisé en ce qu'**il comprend en outre un dispositif de prédistorsion analogique de la dynamique de niveau et de la phase (LINEARIZ) du signal d'émission (RF) placé entre le moyen de compression (COMPRES) et ledit dispositif amplificateur de puissance final radioélectrique (PW-AMP, GaAsFET), l'étendue de la dynamique de niveau et de la prédistorsion de phase en fonction de la puissance du signal à prédistordre (RF) étant telle qu'elle compense lesdites distorsions de phase et d'amplitude introduites par ledit dispositif amplificateur.

FIG.1

FIG.2

FIG.3

FIG.4

FIGURE 5

FIGURE 6

EP 1 164 694 B1

**FIGURE 7**

FIG.8

FIG.9

FIG.10

FIG.11

```
                          ┌───────────┐
                          │   START   │
                          └───────────┘
                                │
                  ┌─────────────────────────┐
                  │   VGnom → VG             │
                  │                          │──── F1
                  │   0 → RFEC(T)            │
                  └─────────────────────────┘
                                │
          ┌───────────────────►─┴─◄───────────────────────┐
          │                                                │
          │              ┌──────────────────┐             │
          │              │ VG = VG + │ΔVG│   │──── F2      │
          │              └──────────────────┘             │
          │                       │                        │
  ┌───────────────────────┐  ┌──────────────────┐          │
  │ RFEC(T+1) → RFEC(T)   │  │ RFEC(T+1) MEAS.   │── F3     │
  └───────────────────────┘  └──────────────────┘          │
   F5      │                          │                     │
           │          si      ◇───────┴────────◇  F4        │
           └──────────────◄───│ RFEC(T+1) ≤ RFEC(T) │       │
                              ◇────────┬───────◇            │
                                       │ no                  │
                                       │                     │
          ┌───────────────────────────┤                     │
          │                           │                     │
          │              ┌──────────────────┐  F6           │
          │              │ VG = VG − │ΔVG│   │              │
          │              └──────────────────┘               │
          │                       │                          │
  ┌───────────────────────┐  ┌──────────────────┐            │
  │ RFEC(T+1) → RFEC(T)   │  │ RFEC(T+1) MEAS.   │── F7       │
  └───────────────────────┘  └──────────────────┘            │
   F9      │                          │                       │
           │          si      ◇───────┴────────◇  F8          │
           └──────────────◄───│ RFEC(T+1) ≤ RFEC(T) │         │
                              ◇────────┬───────◇              │
                                       │ no                    │
                                       └───────────────────────┘
```

FIG.12

FIGURE 13

FIG.15

FIGURE 14

QAM-MOD-COMP

MOD-DIG-COMP

MAP   TX-SHAP

IF-OL
cos       I-comp

DATA   I   Ifx   Ic

Q        Σ

Qfx

Qc

-sin     -90°   Q-comp
         cos

M-comp   D/A   RECONST   IF

TRX/TRXL

RF

QAM-DEMOD-EXP

DEMAP-P/S   STIM   EQUAL   RX-FIR

cos

DATA   Ie   Ifr   A/D   I

I-expand

Qe   Qfr   A/D   Q

IF   RF

Q-expand   RX-FIR   -sin

RIC

EP 1 164 694 B1

29

EP 1 164 694 B1

**FIG. 16**

**Fig. 17**

30

dB

1 dB/13 MHz
4 dB/15 MHz
- 47 dB/24 MHz
- 47 dB/22 MHz
- 105 dB/36 MHz

Frequency from the nominal centre frequency (MHz)

## FIG 18

relative
power
spectral
density
(dB)

15 MHz/+1dB
13 MHz/+1 dB
(c)
21 MHz/-35 dB
20 MHz/-35 dB
31,5 MHz/-65 dB
(a)
(b)
60 MHz/-105 dB

Frequency offset from the actual centre frequency (MHz)

## FIG. 19

31

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0451909 A
- EP 0584534 A1

- US 4766395 A